# EUROPÄISCHE PATENTSCHRIFT

(11) **EP 1 668 772 B1**
(45) Veröffentlichungstag und Bekanntmachung des Hinweises auf die Patenterteilung: **26.03.2008**
(21) Anmeldenummer: 04786745.2
(22) Anmeldetag: 10.09.2004
(51) Int. Cl.: H03B 5/12, H03B 27/00, H03K 3/03

(54) **INJECTION-LOCKED-OSCILLATOR-SCHALTKREIS**
INJECTION-LOCKED OSCILLATOR CIRCUIT
CIRCUIT OSCILLATEUR VERROUILLE PAR INJECTION

(30) Priorität: 29.09.2003 DE 10345195
(43) Veröffentlichungstag der Anmeldung: 14.06.2006
(73) Patentinhaber: Infineon Technologies AG, 81669 München (DE)
(72) Erfinder: MAGET, Judith, 82024 Taufkirchen (DE); TIEBOUT, Marc, 81739 München (DE)
(74) Vertreter: Viering, Hans-Martin
(86) Internationale Anmeldenummer: PCT/DE2004/002023
(87) Internationale Veröffentlichungsnummer: WO 2005/041402

(56) Entgegenhaltungen:
- US-B1- 6 175 285
- US-B1- 6 417 740

## Beschreibung

Die Erfindung betrifft einen Injection-Locked-Oscillator-Schaltkreis.

Für I/Q-Modulation und I/Q-Demodulation in verschiedenen Anwendungen werden Quadratur-Signale gebraucht. Wobei unter I/Q-Modulation verstanden wird, dass eine Komponente der Welle "In Phase" ist und eine zweite Komponente der Welle eine "Quadratur"-Komponente ist, d.h. eine 90°-Phasenverschiebung zu der ersten Komponente aufweist. Die I/Q-Modulation ist ein effizienter Weg, Phasen- und Amplitudeninformation zu übertragen, zumodulieren bzw. zu demodulieren.

Zum Beispiel werden in "Wireless Anwendungen", d.h. beispielsweise im GSM-Mobilfunk, I/Q-Modulation und I/Q-Demodulation angewendet. Auch in "Wireline Anwendungen", beispielsweise bei "Uniphy", werden Signale mit vier Taktphasen verwendet, um ein Eingangssignal mehrfach abzutasten und um die Daten zu detektieren. In Systemen, welche I/Q-(De)Modulation verwenden, wird jeweils ein Signal, auch Systemtakt genannt, mit einer Phasenlage von 0°, d.h. der Systemtakt, welcher sich "In Phase" befindet, und ein Systemtakt mit einer Phasenlage von 90°, d.h. der Systemtakt, welcher das Quadratursignal darstellt, benötigt.

Zum Erzeugen der Systemtakte werden so genannte Oszillator-Schaltkreise, im Weiteren auch als Oszillatorstufe bezeichnet, verwendet. Wird ein solcher Oszillator-Schaltkreis als so genannter Lokaloszillator verwendet, muss er für bestimmte Anwendungen, beispielsweise GSM-Mobilfunk, sehr strenge Spezifikationen in Bezug auf das von ihm ausgehende Phasenrauschen erfüllen. Dem Phasenrauschen als äquivalent kann auch die zeitliche Variation der Abstände zweier Nulldurchgänge, der so genannte Jitter, der vom Oszillator-Schaltkreis ausgehenden Schwingungen, d.h. der Systemtakte, angesehen werden.

Oszillator-Schaltkreise werden häufig als so genannte spannungsgesteuerte Oszillatoren oder VCOs (voltage controlled oscillators) ausgeführt.

Wird ein Oszillator-Schaltkreis als Lokaloszillator für die Frequenztranslation eines zu übertragenden Signals, d.h. der zu übertragenden Information, verwendet, so führt ein Rauschen des Systemtaktes des Lokaloszillators zum "Verwischen", des übertragenen Signals, d.h. zu einer Verschlechterung in der Übertragungsqualität des Signals. Durch dieses Verwischen wird einerseits eine eindeutige Detektion des übertragenen Signals auf der Empfängerseite erschwert, andererseits wird die Weiterverarbeitung des empfangenen Signals erschwert, wenn nicht sogar verhindert [1].

Anzumerken ist, dass Phasenrausch-Spezifikationen, d.h. Grenzwerte für Phasenrauschen, welche bei einer Übertragung eines Signals eingehalten werden müssen, anwendungsspezifisch sind. Zum Beispiel ergeben sich die Phasenrausch-Spezifikationen beim Mobilfunk unter anderem aus den Abständen benachbarter Frequenzkanäle und der innerhalb der einzelnen Frequenzkanälen minimal zu detektierenden Sendeleistung, bzw. der maximal zugelassenen Störleistung.

Aus Kostengründen und zum Ziel gleichzeitiger Integrierbarkeit von analogen und digitalen Funktionen auf einem Chip sollen die VCOs vollintegriert als LC-Oszillatoren [1], [2] in einer CMOS-Technologie ausgebildet werden.

Ein CMOS LC-Oszillator mit Quadratursignal Ausgängen gemäß dem Stand der Technik ist in [3] beschrieben. Der in [3] beschriebene CMOS LC-Oszillator ist prinzipiell zum Erzeugen von I/Q Signalen, d.h. von Taktsignalen oder Systemtakten mit einer Phasenlage von 0° und 90°, geeignet. Die dort beschriebene Vorrichtung weist einen ersten Oszillator-Teilschaltkreis und einen zweiten Oszillator-Teilschaltkreis auf. Die beiden Oszillator-Teilschaltkreise sind mittels eines Transistor-Teilschaltkreises gekoppelt, welcher aus insgesamt acht miteinander gekoppelten Transistoren besteht.

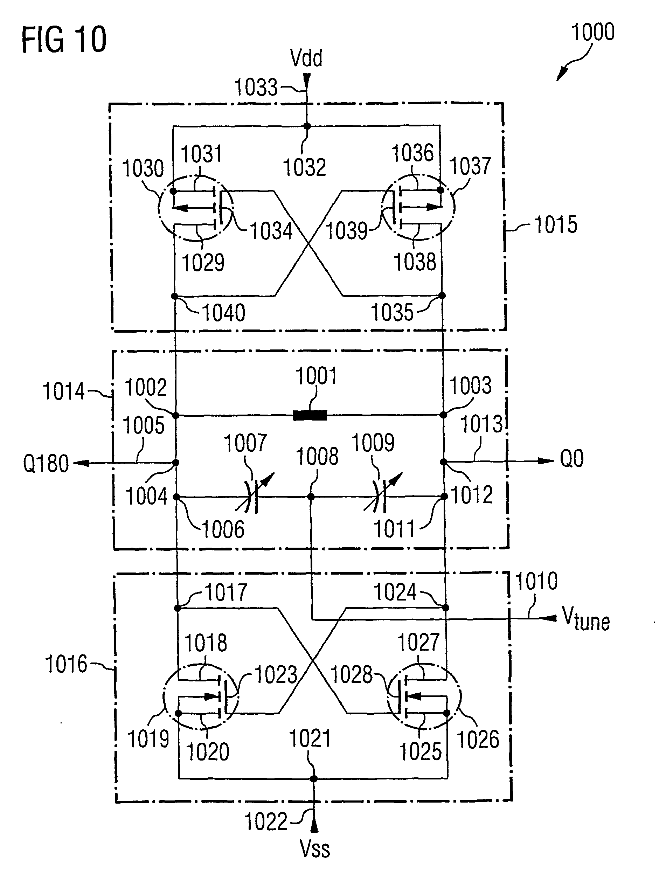

In **Fig. 10** ist ein Prinzipschaltbild eines differentiellen spannungsgesteuerten Oszillators mit kreuzgekoppelten NMOS- und PMOS-Transistoren ohne Stromquelle (üblicherweise wird eine Stromquelle oftmals hinzugefügt) dargestellt, welcher als Basis der nachfolgenden Betrachtungen zu VCOs gemäß dem Stand der Technik angesehen werden kann. Der in Fig. 10 dargestellte VCO 1000 weist eine Induktivität 1001 auf, welche an ihren beiden Enden mit jeweils einem ersten Knoten 1002 und einem zweiten Knoten 1003 gekoppelt ist. Der erste Knoten 1002 ist mit einem dritten Knoten 1004 gekoppelt, welcher mit einem ersten Ausgangsanschluss 1005 des VCO gekoppelt ist. Ferner ist der dritte Knoten 1004 mit einem vierten Knoten 1006 gekoppelt. Der vierte Knoten 1006 ist mit einem ersten Anschluss eines ersten Varaktors 1007, d.h. einer variablen Kapazität, gekoppelt. Ein zweiter Anschluss des ersten Varaktors 1007 ist mit einem fünften Knoten 1008 gekoppelt. Der fünfte Knoten 1008 ist mit einem ersten Anschluss eines zweiten Varaktors 1009 gekoppelt. Ferner ist der fünfte Knoten 1008 mit einer Spannungsquelle 1010 gekoppelt, welche eine Spannung zur Verfügung stellt, welche zum Einstellen der variablen Kapazitäten der Varaktoren 1007 und 1009 dient. Ein zweiter Anschluss des zweiten Varaktors 1009 ist mit einem sechsten Knoten 1011 gekoppelt, welcher sechste Knoten 1011 mit einem siebten Knoten 1012 gekoppelt ist. Der siebte Knoten 1012 ist mit einem zweiten Ausgangsanschluss 1013 des VCO gekoppelt. Ferner ist der siebte Knoten 1012 mit dem zweiten Knoten 1003 gekoppelt. Die beiden Varaktoren 1007 und 1009 können auch als ein einzelner Varaktor ausgebildet sein.

Die oben beschriebenen Elemente der Fig. 10 bilden ein LC-Glied 1014 des VCO. Ferner weist der VCO noch einen ersten so genannten Oszillatortransistor-Teilschaltkreis 1015 und einen zweiten Oszillatortransistor-Teilschaltkreis 1016 auf. Beide Transistor-Teilschaltkreise weisen jeweils zwei miteinander kreuzweise verschaltete Transistoren auf.

Der erste Ausgangsanschluss 1005 und der zweite Ausgangsanschluss 1013 stellen die Ausgangsanschlüsse des VCO dar, an welchen die Ausgangssignale des VCO zur Verfügung gestellt werden, wobei die Ausgangssignale relativ zueinander um 180° phasenverschoben sind.

Im Detail sieht der zweite Oszillatortransistor-Teilschaltkreis 1016 aus Fig. 10 wie folgt aus.

Der vierte Knoten 1006 ist mit einem achten Knoten 1017 gekoppelt. Der achte Knoten 1017 ist mit einem ersten Source/Drain-Anschluss 1018 eines ersten Transistors 1019 gekoppelt. Der zweite Source/Drain-Anschluss 1020 des ersten Transistors 1019 ist mit einem neunten Knoten 1021 gekoppelt. Der neunte Knoten 1021 ist mit einer Spannungsquelle 1022 gekoppelt, welche die Bezugsspannung für den VCO zur Verfügung stellt. Der Gateanschluss 1023 des ersten Transistors 1019 ist mit einem zehnten Knoten 1024 gekoppelt. Der neunte Knoten 1021 ist ferner mit einem ersten Source/Drain-Anschluss 1025 eines zweiten Transistors 1026 gekoppelt. Der zweite Source/Drain-Anschluss 1027 des zweiten Transistors 1026 ist mit dem zehnten Knoten 1024 gekoppelt und der Gateanschluss 1028 des zweiten Transistors 1026 ist mit dem achten Knoten 1017 gekoppelt. Ferner ist der zehnte Knoten 1024 mit dem sechsten Knoten 1011 gekoppelt.

Im Detail sieht der erste Oszillator-Transistor-Teilschaltkreis 1015 aus Fig. 10 wie folgt aus.

Der erste Knoten 1002 ist mit einem elften Knoten 1040 gekoppelt. Der elfte Knoten 1040 ist mit einem ersten Source/Drain-Anschluss 1029 eines dritten Transistors 1030 gekoppelt. Der zweite Source/Drain-Anschluss 1031 des dritten Transistors 1030 ist mit einem zwölften Knoten 1032 gekoppelt. Der zwölfte Knoten 1032 ist mit einer Spannungsquelle 1033 gekoppelt, welche die Versorgungsspannung für den VCO zur Verfügung stellt. Der Gateanschluss 1034 des dritten Transistors 1030 ist mit einem dreizehnten Knoten 1035 gekoppelt. Der zwölfte Knoten 1032 ist ferner mit einem ersten Source/Drain-Anschluss 1036 eines vierten Transistors 1037 gekoppelt. Der zweite Source/Drain-Anschluss 1038 des vierten Transistors 1037 ist mit dem dreizehnten Knoten 1035 gekoppelt und der Gateanschluss 1039 des vierten Transistors 1037 ist mit dem elften Knoten 1040 gekoppelt. Ferner ist der dreizehnte Knoten 1035 mit dem zweiten Knoten 1003 gekoppelt.

In Fig. 10 weisen die vier Transistoren zusätzlich jeweils einen Bulk-Anschluss auf, welche bei dem ersten Transistor 1019 und dem zweiten Transistor 1026 mit der Bezugsspannungsquelle 1022 gekoppelt sind, wohingegen der Bulk-Anschluss des dritten Transistors 1030 und des vierten Transistors 1037 mit der Versorgungsspannungsquelle 1033 gekoppelt sind.

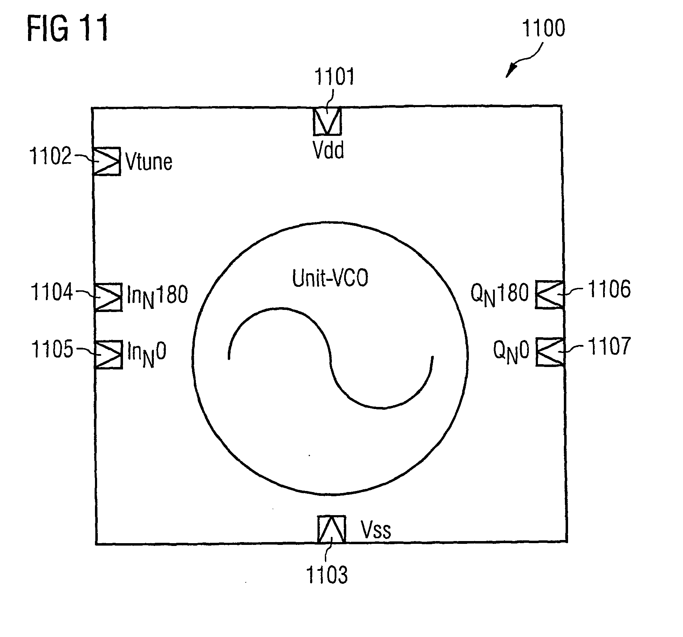

Im Stand der Technik sind verschiedene Arten der Kopplungen von mehreren VCOs zu einem so genannten Oszillatorring bekannt, welche nachfolgend kurz beschrieben werden. Die einzelnen VCOs eines Oszillatorringes werden auch als Oszillatorstufen bezeichnet. In der **Fig. 11** ist symbolisch eine einzelne Oszillatorstufe dargestellt.

In der symbolischen Darstellung weist eine einzelne Oszillatorstufe 1100 einen ersten Spannungsversorgungsanschluss 1101 auf, über welchen der Oszillatorstufe 1100 eine Versorgungsspannung zur Verfügung gestellt wird. Ferner weist die Oszillatorstufe 1100 einen zweiten Spannungsversorgungsanschluss 1102 auf, über welchen die Oszillatorstufe 1100 mit einer Abstimmspannung für in der Oszillatorstufe 1100 vorgesehene Varaktoren versorgt wird. Die Oszillatorstufe 1100 weist ferner einen dritten Spannungsversorgungsanschluss 1103 auf, über welchen die Oszillatorstufe 1100 mit einer Bezugsspannung versorgt wird. Ferner weist die Oszillatorstufe 1100 zwei Kopplungseingänge 1104 und 1105 auf, welche dazu dienen, der Oszillatorstufe 1100 zwei Eingangssignale zur Verfügung zu stellen. Die beiden Eingangssignale haben hierbei eine relative Phasenverschiebung von 180° zueinander. Die Oszillatorstufe 1100 weist ferner zwei Kopplungsausgänge 1106 und 1107 auf, welche dazu dienen, zwei Ausgangssignale der Oszillatorstufe 1100 auszukoppeln. Die beiden Ausgangssignale haben hierbei eine relative Phasenverschiebung von 180° zueinander.

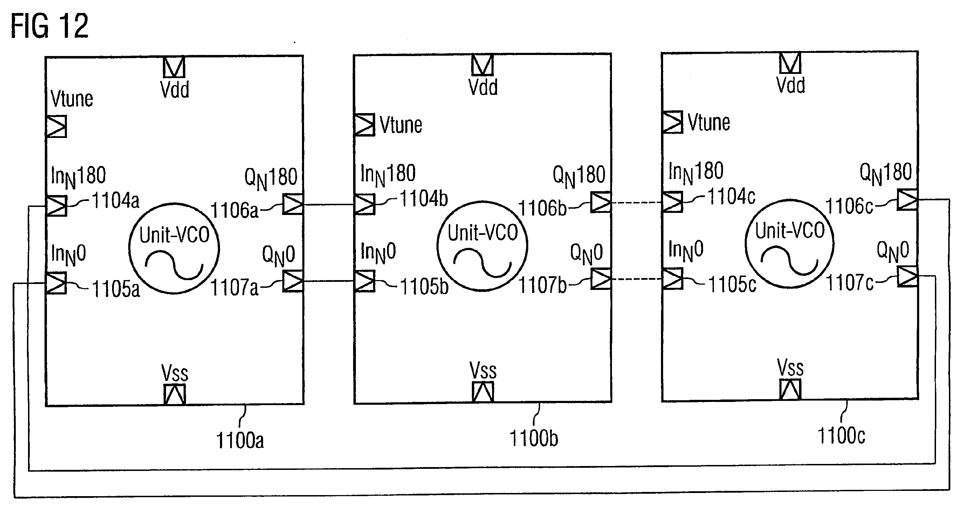

Die Verkopplung mehrerer solcher Oszillatorstufen ist schematisch in **Fig. 12** dargestellt. Die Abstimmspannung, Bezugsspannung und Versorgungsspannung sind hierbei für alle Oszillatorstufen gleich und die Kopplung der einzelnen Spannungsquellen ist in Fig. 12 nicht dargestellt.

In Fig. 12 sind schematisch drei Oszillatorstufen 1100a, 1100b und 1100c, wie sie in Fig. 11 dargestellt sind, miteinander verkoppelt. Zu bemerken ist ferner, dass die einzelnen Oszillatorstufen, außer einer einzelnen so genannten Kreuzkopplung, untereinander mittels so genannter direkter Kopplungen gekoppelt sind, d.h. das Ausgangssignal mit einer Phasenlage von 180° wird an den Eingangsanschluss mit einer Phasenlage von 180° angelegt, bzw. das Ausgangssignal mit einer Phasenlage von 0° wird an den Eingangsanschluss mit einer Phasenlage von 0° angelegt. Bei einer Kopplung der einzelnen Oszillatorstufen werden jeweils die Ausgangsanschlüsse einer Oszillatorstufe mit.den Eingangsanschlüssen der nächsten Oszillatorstufe gekoppelt.

Nachfolgend wird die schematische Darstellung von gekoppelten Oszillatorstufen im Detail beschrieben. Ein erster Ausgangsanschluss 1106a einer ersten Oszillatorstufe 1100a, welcher beispielsweise ein Signal mit einer Phasenlage von 180° bereitstellt, wird mit einem ersten Eingangsanschluss 1104b einer zweiten Oszillatorstufe 1100b gekoppelt, welcher Eingangsanschluss eine Phasenlage von 180° aufweist. Ein zweiter Ausgangsanschluss 1107a der ersten Oszillatorstufe 1100a, welcher im Beispiel ein Signal mit einer Phasenlage von 0° bereitstellt, wird mit einem zweiten Eingangsanschluss 1105b der zweiten Oszillatorstufe 1100b gekoppelt, welcher Eingangsanschluss eine Phasenlage von 0° aufweist.

Ferner ist ein erster Ausgangsanschluss 1106b der zweiten Oszillatorstufe 1100b, welcher im Beispiel ein Signal mit einer Phasenlage von 180° bereitstellt, wird mit einem ersten Eingangsanschluss 1104c einer dritten Oszillatorstufe 1100c gekoppelt, welcher Eingangsanschluss eine Phasenlage von 180° aufweist. Ein zweiter Ausgangsanschluss 1107b der zweiten Oszillatorstufe 1100b, welcher im Beispiel ein Signal mit einer Phasenlage von 0° bereitstellt, wird mit einem zweiten Eingangsanschluss 1105c einer dritten Oszillatorstufe 1100c gekoppelt, welcher Eingangsanschluss eine Phasenlage von 0° aufweist.

Es können zusätzliche Oszillatorstufen in der bisher beschriebenen Weise angekoppelt werden. In Fig. 12 ist dies durch die gestrichelt dargestellten Kopplungen zwischen der zweiten Oszillatorstufe 1100b und der dritten Oszillatorstufe 1100c angedeutet.

Die letzte Oszillatorstufe, in der Fig. 12 die dritte Oszillatorstufe 1100c, wird mit der ersten Oszillatorstufe 1100a gekoppelt. Bei dieser Kopplung ist zu beachten, dass diese Kopplung eine Kreuzkopplung ist.

Im Detail ist die Kopplung der dritten Oszillatorstufe 1100c an die erste Oszillatorstufe 1100a wie folgt. Ein erster Ausgangsanschluss 1106c der dritten Oszillatorstufe 1100c, welcher im Beispiel ein Signal mit einer Phasenlage von 180° bereitstellt, wird mit einem zweiten Eingangsänschluss 1105a der dritten Oszillatorstufe 1100a gekoppelt, welcher Eingangsanschluss eine Phasenlage von 0° aufweist. Ein zweiter Ausgangsanschluss 1107c der dritten Oszillatorstufe 1100c, welcher im Beispiel ein Signal mit einer Phasenlage von 0° bereitstellt, wird mit einem ersten Eingangsanschluss 1104a der ersten Oszillatorstufe 1100a gekoppelt, welcher Eingangsanschluss eine Phasenlage von 180° aufweist.

Für eine stabile Oszillation muss die Phasendrehung entlang der gesamten Anzahl von Oszillatorstufen, d.h. entlang des so genannten Oszillatorrings, ein Vielfaches von 2n betragen. Zu beachten ist ferner, dass bei der Anordnung einer Mehrzahl von Oszillatorstufen in einem Oszillatorring der Stromverbrauch des Oszillatorringes ansteigt, da eine erhöhte Anzahl von Strompfaden zwischen der Versorgungsspannung (Vdd) und der Bezugsspannung (Vss) gegeben ist. Der Anstieg des Stromverbrauchs ist hierbei in etwa linear mit der Anzahl der verwendeten Oszillatorstufen.

Prinzipiell sind zwei Realisierungsmöglichkeiten der Kopplungseingänge in den einzelnen Oszillatorstufen bekannt. Dies ist einerseits die so genannte serielle Kopplung, welche beispielsweise in [4] und [5] beschrieben ist, und andererseits die so genannte parallele Kopplung, welche beispielsweise in [6], [7] und [8] beschrieben sind. Beide Kopplungsarten und insbesondere die entsprechende Ausgestaltung der Oszillatorstufen werden nachfolgend genauer erläutert.

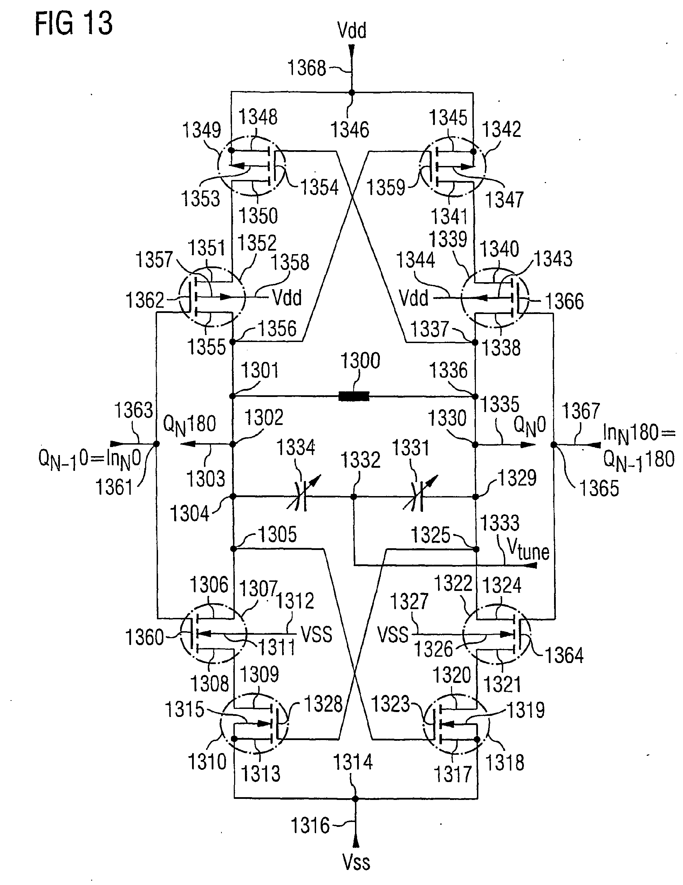

Zuerst wird anhand der **Fig. 13** eine Oszillator-Grundstufe für eine serielle Kopplung beschrieben. Eine Induktivität 1300 ist an einem ersten Ende mit einem ersten Knoten 1301 gekoppelt. Der erste Knoten 1301 ist mit einem zweiten Knoten 1302 gekoppelt. Der zweite Knoten 1302 ist mit einem ersten Ausgangsanschluss 1303 gekoppelt. Ferner ist der zweite Knoten 1302 mit einem dritten Knoten 1304 gekoppelt. Der dritte Knoten 1304 ist mit einem vierten Knoten 1305 gekoppelt. Der vierte Knoten 1305 ist mit einem ersten Source/Drain-Anschluss 1306 eines ersten Transistors 1307 gekoppelt. Der zweite Source/Drain-Anschluss 1308 des ersten Transistors ist mit einem ersten Source/Drain-Anschluss 1309 eines zweiten Transistors 1310 gekoppelt. Ferner ist ein Bulk-Anschluss 1311 des ersten Transistors mit einer Bezugsspannungsquelle 1312 gekoppelt. Der zweite Source/Drain-Anschluss 1313 des zweiten Transistors 1310 ist mit einem fünften Knoten 1314 gekoppelt. Ferner ist ein Bulk-Anschluss 1315 mit dem zweiten Source/Drain-Anschluss 1313 des zweiten Transistors 1310 gekoppelt. Der fünfte Knoten 1314 ist mit einer Bezugsspannungsquelle 1316 gekoppelt. Der fünfte Knoten 1314 ist ferner mit einem ersten Source/Drain-Anschluss 1317 eines dritten Transistors 1318 gekoppelt und der erste Source/Drain-Anschluss 1317 des dritten Transistors 1318 ist mit einem Bulk-Anschluss 1319 des dritten Transistors 1318 gekoppelt. Der zweite Source/Drain-Anschluss 1320 des dritten Transistors 1318 ist mit einem ersten Source/Drain-Anschluss 1321 eines vierten Transistors 1322 gekoppelt. Der Gateanschluss 1323 des dritten Transistors 1318 ist mit dem vierten Knoten 1305 gekoppelt. Der zweite Source/Drain-Anschluss 1324 des vierten Transistors 1322 ist mit einem sechsten Knoten 1325 gekoppelt. Ein Bulk-Anschluss 1326 des vierten Transistors 1322 ist mit einer Bezugsspannungsquelle 1327 gekoppelt. Der sechste Knoten 1325 ist mit dem Gateanschluss 1328 des zweiten Transistors 1310 gekoppelt. Ferner ist der sechste Knoten 1325 mit einem siebten Knoten 1329 gekoppelt. Der siebte Knoten 1329 ist mit einem achten Knoten 1330 gekoppelt. Ferner ist der siebte Knoten 1329 mit einem ersten Anschluss eines ersten Varaktors 1331 gekoppelt. Der zweite Anschluss des ersten Varaktors 1331 ist mit einem neunten Knoten 1332 gekoppelt. Der neunte Knoten 1332 ist mit einer Abstimmspannungsquelle 1333 gekoppelt. Ferner ist der neunte Knoten 1332 mit einem ersten Anschluss eines zweiten Varaktors 1334 gekoppelt. Der zweite Anschluss des Varaktors 1334 ist mit dem dritten Knoten 1304 gekoppelt.

Die Abstimmspannungsquelle 1333 wird dazu verwendet den beiden Varaktoren 1331 und 1334 eine Spannung zum Abstimmen der Kapazität bereitzustellen. Die beiden Varaktoren können auch als ein einzelner Varaktor ausgebildet sein. Die Spannungen, welche mittels der Bezugsspannungsquellen 1312, 1316 und 1327 bereitgestellt werden, sind gleich groß und werden im Folgenden und in den Figuren auch als Vss bezeichnet.

Der achte Knoten 1330 ist mit einem zweiten Ausgangsanschluss 1335 gekoppelt, welcher ein Signal zum Ausgeben bereitstellt, welches um 180° phasenverschoben gegenüber dem am ersten Ausgangsanschluss 1303 anliegenden Signal ist. Der achte Knoten 1330 ist ferner mit einem zehnten Knoten 1336 gekoppelt. Der zehnte Knoten 1336 ist mit dem zweiten Anschluss der Induktivität 1300 gekoppelt.

Der zehnte Knoten 1336 ist ferner mit einem elften Knoten 1337 gekoppelt. Der elfte Knoten 1337 ist mit einem ersten Source/Drain-Anschluss 1338 eines fünften Transistors 1339 gekoppelt. Der zweite Source/Drain-Anschluss 1340 des fünften Transistors 1339 ist mit einem ersten Source/Drain-Anschluss 1341 eines sechsten Transistors 1342 gekoppelt. Ein Bulk-Anschluss 1343 des fünften Transistors 1339 ist mit einer ersten Versorgungsspannungsquelle 1344 gekoppelt. Der zweite Source/Drain-Anschluss 1345 des sechsten Transistors 1342 ist mit einem zwölften Knoten 1346 gekoppelt. Ein Bulk-Anschluss 1347 des sechsten Transistors 1342 ist mit dem zweiten Source/Drain-Anschluss 1345 des sechsten Transistors 1342 gekoppelt. Der zwölfte Knoten 1346 ist mit einer zweiten Versorgungsspannungsquelle 1368 gekoppelt. Ferner ist der zwölfte Knoten mit einem ersten Source/Drain-Anschluss 1348 eines siebten Transistors 1349 gekoppelt. Der zweite Source/Drain-Anschluss 1350 des siebten Transistors 1349 ist mit einem ersten Source/Drain-Anschluss 1351 eines achten Transistors 1352 gekoppelt. Ein Bulk-Anschluss 1353 des siebten Transistors 1349 ist mit dem ersten Source/Drain-Anschluss 1348 des siebten Transistors 1349 gekoppelt. Der Gateanschluss 1354 des siebten Transistors 1349 ist mit dem elften Knoten 1337 gekoppelt. Der zweite Source/Drain-Anschluss 1355 des achten Transistors 1352 ist mit einem dreizehnten Knoten 1356 gekoppelt. Ein Bulk-Anschluss 1357 des achten Transistors 1352 ist mit einer dritten Versorgungsspannungsquelle 1358 gekoppelt. Der dreizehnte Knoten 1356 ist mit dem ersten Knoten 1301 gekoppelt. Ferner ist der dreizehnte Knoten 1356 mit dem Gateanschluss 1359 des sechsten Transistors 1342 gekoppelt.

Die Spannungen, welche mittels der Versorgungsspannungsquellen 1344, 1347 und 1358 bereitgestellt werden, sind gleich groß und werden im Folgenden und in den Figuren auch als Vdd bezeichnet.

Bisher wurde anhand der Fig. 13 die Oszillatorstufe und die beiden differentiellen Ausgangsschlüsse beschrieben. Die Oszillatorstufe weist jedoch zusätzlich noch Eingangsanschlüsse auf, welche nachfolgend beschrieben werden.

Die Eingangsanschlüsse werden mittels der Gateanschlüsse des ersten, vierten, fünften und achten Transistors ausgebildet. Hierzu ist der Gateanschluss 1360 des ersten Transistors 1307 mit einem vierzehnten Knoten 1361 gekoppelt. Der vierzehnte Knoten 1361 ist mit dem Gateanschluss 1362 des achten Transistors 1352 gekoppelt. Ferner ist der vierzehnte Knoten 1361 mit einem ersten Eingangsanschluss 1363 gekoppelt.

Der Gateanschluss 1364 des vierten Transistors 1322 ist mit einem fünfzehnten Knoten 1365 gekoppelt, welcher fünfzehnte Knoten 1365 mit dem Gateanschluss 1366 des fünften Transistors 1339 gekoppelt ist. Der fünfzehnte Knoten 1365 ist ferner mit einem zweiten Eingangsanschluss 1367 gekoppelt.

Im Allgemeinen stellen der erste Transistor, der vierte Transistor, der fünfte Transistor und der achte Transistor Koppeltransistoren der Oszillatorstufe dar, wohingegen der zweite Transistor, der dritte Transistor, der sechste Transistor und der siebte Transistor Oszillatortransistoren der Oszillatorstufe darstellen.

Anhand der Fig. 13 lässt sich auch genauer erklären, was unter der oben bereits erwähnten direkten Kopplung und der Kreuzkopplung zu verstehen ist.

Beispielsweise weist das Signal am ersten Ausgangsanschluss 1303 einer ersten Oszillatorstufe eine Phasenlage von 180° auf. Bei einer direkten Kopplung wird dieses Ausgangssignal des ersten Ausgangsanschlusses 1303 an den zweiten Eingangsanschluss 1367 der nachfolgenden Oszillatorstufe gekoppelt. Das Signal, welches am zweiten Ausgangsanschluss 1335 der ersten Oszillatorstufe anliegt und welches eine Phasenlage von 0° aufweist, wird an den ersten Eingangsanschluss 1363 der nachfolgenden Oszillatorstufe gekoppelt.

Im Gegensatz dazu sieht die Kreuzkopplung wie folgt aus.

Beispielsweise weist das Signal am ersten Ausgangsanschluss 1303 einer ersten Oszillatorstufe eine Phasenlage von 180° auf. Bei einer Kreuzkopplung wird dieses Ausgangssignal des ersten Ausgangsanschlusses 1303 an den ersten Eingangsanschluss 1363 der nachfolgenden Oszillatorstufe gekoppelt. Das Signal, welches am zweiten Ausgangsanschluss 1335 der ersten Oszillatorstufe anliegt und welches eine Phasenlage von 0° aufweist, wird an den zweiten Eingangsanschluss 1367 der nachfolgenden Oszillatorstufe gekoppelt.

Bei einer seriellen Kopplung von Oszillatorstufen ist jede beliebige Anzahl von Stufen möglich. Die Phasendifferenz zwischen den aufeinanderfolgenden Stufen ist hierbei abhängig von der Anzahl der Stufen, welche in einem Oszillatorring vorhanden sind. Die Phasenverschiebung innerhalb des gesamten Oszillatorringes muss hierbei ein Vielfaches von 2n betragen.

Ein Nachteil eines seriellen Oszillatorringes ist jedoch, dass aufgrund der seriellen Kopplung sowohl die Oszillatorals auch die Koppeltransistoren eine relativ große Weite aufweisen müssen, um genügend Strom durch den jeweiligen aktiven Ast der Schaltung zu ermöglichen, weil sich die Oszillator- und die Koppeltransistoren nicht im gleichen Zustand befinden. Dadurch ergeben sich hohe parasitäre Kapazitäten innerhalb des Oszillatorringes, welche sich negativ auf das Frequenzabstimmvermögen und den Stromverbrauch des Oszillatorringes auswirken. Ein zusätzlicher Nachteil ist, dass durch die Vergrößerung der Abmessungen der Transistoren, welche mit den relativ großen Weiten der Transistoren einhergeht, die Gefahr besteht, dass das Eigenrauschen der Transistoren erhöht wird, was wiederum zu einem höheren Phasenrauschen des Oszillators beiträgt.

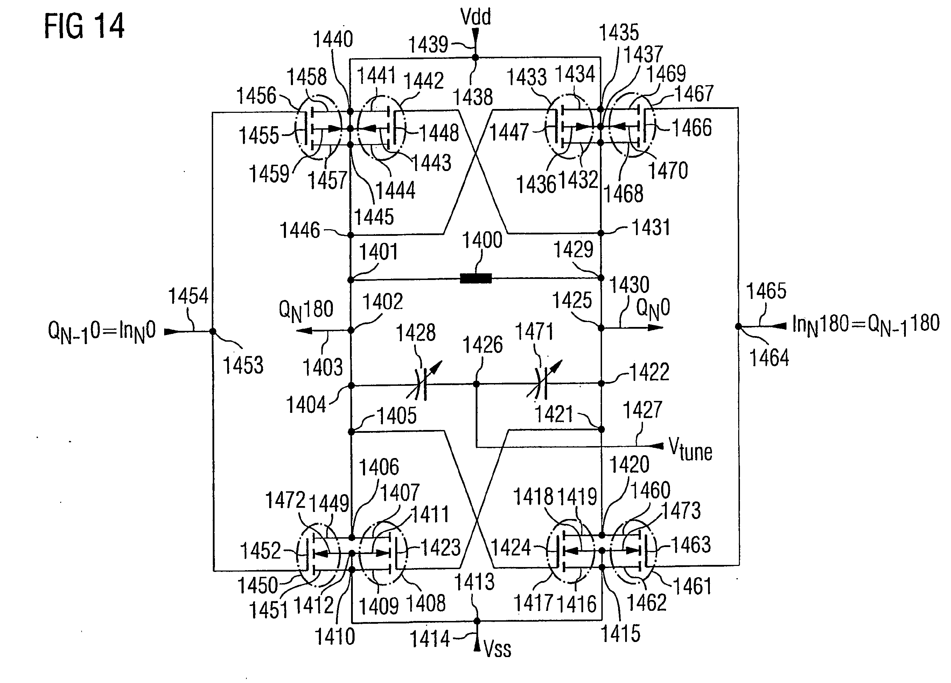

Nachfolgend wird anhand der **Fig. 14** eine Oszillator-Grundstufe für eine parallele Kopplung beschrieben. Eine Induktivität 1400 ist an einem ersten Ende mit einem ersten Knoten 1401 gekoppelt. Der erste Knoten 1401 ist mit einem zweiten Knoten 1402 gekoppelt. Der zweite Knoten 1402 ist mit einem ersten Ausgangsanschluss 1403 gekoppelt. Ferner ist der zweite Knoten 1402 mit einem dritten Knoten 1404 gekoppelt. Der dritte Knoten 1404 ist mit einem vierten Knoten 1405 gekoppelt. Der vierte Knoten 1405 ist mit einem fünften Knoten 1406 gekoppelt. Der fünfte Knoten 1406 ist mit einem ersten Source/Drain-Anschluss 1407 eines ersten Transistors 1408 gekoppelt. Der zweite Source/Drain-Anschluss 1409 des ersten Transistors 1408 ist mit einem sechsten Knoten 1410 gekoppelt. Ferner ist ein Bulk-Anschluss 1411 des ersten Transistors 1408 mit einem siebten Knoten 1412 gekoppelt. Der siebte Knoten 1412 ist mit dem sechsten Knoten 1410 gekoppelt. Der sechste Knoten 1410 ist ferner mit einem achten Knoten 1413 gekoppelt. Der achte Knoten 1413 ist mit einer Bezugsspannungsquelle 1414 gekoppelt. Der achte Knoten 1413 ist ferner mit einem neunten Knoten 1415 gekoppelt, welcher mit einem ersten Source/Drain-Anschluss 1416 eines zweiten Transistors 1417 gekoppelt ist. Ferner ist der neunte Knoten 1415 mit einem Bulk-Anschluss 1418 des zweiten Transistors 1417 gekoppelt. Der zweite Source/Drain-Anschluss 1419 des zweiten Transistors 1417 ist mit einem zehnten Knoten 1420 gekoppelt. Der zehnte Knoten 1420 ist mit einem elften Knoten 1421 gekoppelt. Der elfte Knoten 1421 ist mit einem zwölften Knoten 1422 gekoppelt.

Ferner ist der elfte Knoten 1421 mit dem Gateanschluss 1423 des ersten Transistors 1408 gekoppelt und der Gateanschluss 1424 des zweiten Transistors 1417 ist mit dem vierten Knoten 1405 gekoppelt.

Der zwölfte Knoten 1422 ist mit einem dreizehnten Knoten 1425 gekoppelt. Ferner ist der zwölfte Knoten 1422 mit einem ersten Anschluss eines ersten Varaktors 1471 gekoppelt. Der zweite Anschluss des ersten Varaktors 1471 ist mit einem vierzehnten Knoten 1426 gekoppelt. Der vierzehnte Knoten 1424 ist mit einer Abstimmspannungsquelle 1427 gekoppelt. Ferner ist der vierzehnte Knoten 1426 mit einem ersten Anschluss eines zweiten Varaktors 1428 gekoppelt. Der zweite Anschluss des Varaktors 1428 ist mit dem dritten Knoten 1404 gekoppelt.

Die beiden Varaktoren 1471 und 1428 können auch als ein einzelner Varaktor ausgebildet sein.

Der dreizehnte Knoten 1425 ist mit einem fünfzehnten Knoten 1429 gekoppelt. Ferner ist der dreizehnte Knoten 1425 mit einem zweiten Ausgangsanschluss 1430 gekoppelt. Der fünfzehnte Knoten 1429 ist mit einem sechzehnten Knoten 1431 und ferner mit dem zweiten Anschluss der Induktivität 1400 gekoppelt.

Der sechzehnte Knoten 1431 ist mit einem dritten Source/Drain-Anschluss 1432 eines dritten Transistors 1433 gekoppelt. Der zweite Source/Drain-Anschluss 1434 des ersten Transistors 1433 ist mit einem siebzehnten Knoten 1435 gekoppelt. Ferner ist ein Bulk-Anschluss 1436 des dritten Transistors 1433 mit einem achtzehnten Knoten 1437 gekoppelt. Der achtzehnte Knoten 1437 ist mit dem siebzehnten Knoten 1435 gekoppelt. Der siebzehnte Knoten 1435 ist ferner mit einem neunzehnten Knoten 1438 gekoppelt. Der neunzehnte Knoten 1438 ist mit einer Versorgungsspannungsquelle 1439 gekoppelt. Der neunzehnte Knoten 1438 ist ferner mit einem zwanzigsten Knoten 1440 gekoppelt, welcher mit einem ersten Source/Drain-Anschluss 1441 eines vierten Transistors 1442 gekoppelt ist. Ferner ist der zwanzigste Knoten 1440 mit einem Bulk-Anschluss 1443 des vierten Transistors 1442 gekoppelt. Der zweite Source/Drain-Anschluss 1444 des vierten Transistors 1442 ist mit einem einundzwanzigsten Knoten 1445 gekoppelt. Der einundzwanzigsten Knoten 1445 ist mit einem zweiundzwanzigsten Knoten 1446 gekoppelt. Der zweiundzwanzigste Knoten 1446 ist mit dem ersten Knoten 1401 gekoppelt.

Ferner ist der zweiundzwanzigste Knoten 1446 mit dem Gateanschluss 1447 des dritten Transistors 1433 gekoppelt und der Gateanschluss 1448 des vierten Transistors 1442 ist mit dem sechzehnten Knoten 1431 gekoppelt.

Bisher wurde anhand der Fig. 14 die Oszillatorstufe und die beiden differentiellen Ausgangsschlüsse beschrieben. Die Oszillatorstufe weist jedoch zusätzlich noch Eingangsanschlüsse auf, welche nachfolgend beschrieben werden.

Die Eingangsanschlüsse, werden mittels der Gateanschlüsse vierer zusätzlicher Transistoren ausgebildet, welche den ersten vier Transistoren parallel geschaltet sind.

Der fünfte Knoten 1406 ist mit einem ersten Source/Drain-Anschluss 1449 eines fünften Transistors 1450 gekoppelt. Der zweite Source/Drain-Anschluss 1451 des fünften Transistors 1450 ist mit dem sechsten Knoten 1410 gekoppelt. Ein Bulk-Anschluss 1472 des fünften Transistors 1450 ist mit dem siebten Knoten 1412 gekoppelt. Der Gateanschluss 1452 des fünften Transistors 1450 ist mit einem dreiundzwanzigsten Knoten 1453 gekoppelt. Der dreiundzwanzigsten Knoten 1453 ist mit einem ersten Eingangsanschluss 1454 gekoppelt. Ferner ist der dreiundzwanzigste Knoten 1453 mit dem Gateanschluss 1455 eines sechsten Transistors 1456 gekoppelt. Ein erster Source/Drain-Anschluss 1457 des sechsten Transistors 1456 ist mit dem einundzwanzigsten Knoten 1445 gekoppelt. Der zweite Source/Drain-Anschluss 1458 des sechsten Transistors 1456 ist mit dem zwanzigsten Knoten 1440 gekoppelt. Ferner ist ein Bulk-Anschluss 1459 des sechsten Transistors 1456 mit dem zwanzigsten Knoten 1440 gekoppelt.

Der zehnte Knoten 1420 ist mit einem ersten Source/Drain-Anschluss 1460 eines siebten Transistors 1461 gekoppelt. Der zweite Source/Drain-Anschluss 1462 des siebten Transistors 1461 ist mit dem neunten Knoten 1415 gekoppelt. Ein Bulk-Anschluss 1473 des siebten Transistors 1461 ist mit dem neunten Knoten 1415 gekoppelt. Der Gateanschluss 1463 des siebten Transistors 1461 ist mit einem vierundzwanzigsten Knoten 1464 gekoppelt. Der vierundzwanzigsten Knoten 1464 ist mit einem zweiten Eingangsanschluss 1465 gekoppelt. Ferner ist der vierundzwanzigsten Knoten 1454 mit dem Gateanschluss 1466 eines achten Transistors 1467 gekoppelt. Ein erster Source/Drain-Anschluss 1468 des achten Transistors 1467 ist mit dem sechzehnten Knoten 1431 gekoppelt. Der zweite Source/Drain-Anschluss 1469 des achten Transistors 1467 ist mit dem siebzehnten Knoten 1435 gekoppelt. Ferner ist ein Bulk-Anschluss 1470 des achten Transistors 1467 mit dem achtzehnten Knoten 1427 gekoppelt.

Im Allgemeinen stellen der erste Transistor, der zweite. Transistor, der dritte Transistor und der vierte Transistor Oszillationstransistoren der Oszillatorstufe dar, wohingegen der fünfte Transistor, der sechste Transistor, der siebte Transistor und der achte Transistor Koppeltransistoren der Oszillatorstufe darstellen.

Anhand der Fig. 14 lässt sich ebenfalls genauer erklären, was unter der oben bereits erwähnten direkten Kopplung und der Kreuzkopplung zu verstehen ist.

Beispielsweise weist das Signal am ersten Ausgangsanschluss 1403 einer ersten Oszillatorstufe eine Phasenlage von 180° auf. Bei einer direkten Kopplung wird dieses Ausgangssignal vom ersten Ausgangsanschluss 1403 an den zweiten Eingangsanschluss 1465 der nachfolgenden Oszillatorstufe gekoppelt. Das Signal, welches am zweiten Ausgangsanschluss 1430 der ersten Oszillatorstufe anliegt und welches eine Phasenlage von 0° aufweist, wird an den ersten Eingangsanschluss 1454 der nachfolgenden Oszillatorstufe gekoppelt.

Im Gegensatz dazu sieht die Kreuzkopplung wie folgt aus.

Beispielsweise weist das Signal am ersten Ausgangsanschluss 1403 einer ersten Oszillatorstufe eine Phasenlage von 180° auf. Bei einer Kreuzkopplung wird dieses Ausgangssignal vom ersten Ausgangsanschluss 1403 an den ersten Eingangsanschluss 1454 der nachfolgenden Oszillatorstufe gekoppelt. Das Signal, welches am zweiten Ausgangsanschluss 1430 der ersten Oszillatorstufe anliegt und welches eine Phasenlage von 0° aufweist, wird an den zweiten Eingangsanschluss 1465 der nachfolgenden Oszillatorstufe gekoppelt.

Bei einer parallelen Kopplung von Oszillatorstufen ist jede beliebige Anzahl von Stufen möglich. Die Phasendifferenz zwischen den aufeinanderfolgenden Stufen ist hierbei abhängig von der Anzahl der Stufen, welche in einem Oszillatorring vorhanden sind, z.B. sind bei der Verwendung von zwei Oszillatorstufen die Signale in Quadratur, da sich eine Phasendrehung von ±90° ergibt.

Mittels einer parallelen Kopplung von Oszillatorstufen sind im Vergleich zu der seriellen Kopplung kleinere Weiten sowohl der Oszillations- als auch der Kopplungsoszillatoren möglich, da sich bei der in Fig. 14 gezeigten Parallelschaltung jeweils zweier Transistoren die Ströme addieren. Dadurch kann der Varaktor, der nötig ist, um eine Abdeckung eines vorgegebenen Frequenzbereichs zu ermöglichen, ebenfalls verkleinert werden. Dies wiederum erlaubt eine Vergrößerung der Induktivität und damit eine zusätzliche Verringerung sowohl des Phasenrauschens als auch des Stromverbrauchs des Oszillatorringes mit paralleler Kopplung der Oszillatorstufen.

Mittels einer parallelen Kopplung von Oszillatorstufen ist im Vergleich zu einstufigen Oszillatoren mit korrespondierender Grundzelle, d.h. eine Grundzelle wie in Fig. 10 dargestellt, laut Simulationsberechnungen eine Verringerung des Phasenrauschens möglich. Für einen Oszillatorring aus zwei parallel geschalteten Oszillatorstufen ergeben sich in Simulationen bei einer Oszillatorfrequenz zwischen 3,0 GHZ und 4,2 GHz eine Verringerung des Phasenrauschens um bis zu 7 dBc. Für einen Oszillatorring aus vier parallel geschalteten Oszillatorstufen ergeben sich in Simulationen bei einer Oszillatorfrequenz zwischen 3,0 GHZ und 4,2 GHz gegenüber einen Oszillatorring aus zwei parallel geschalteten Oszillatorstufen eine Verringerung des Phasenrauschens um etwa 8 dBc/Hz, wobei dBc "dB with respect to carrier power" bedeutet.

Gegenüber der seriellen Kopplung zeigt eine parallele Kopplung der einzelnen Oszillatorstufen, bei einer Anzahl von vier Oszillatorstufen, laut Simulationen eine Verbesserung bis zu 8 dBc/Hz.

Ein wesentlicher Nachteil der parallelen Kopplung von Oszillatorstufen zu einen Oszillatorring liegt darin, dass es sich herausgestellt hat, dass mehrere Oszillatorzustände möglich sind. Hierdurch weisen einige Exemplare der Oszillatorringe mit paralleler Kopplung anstelle von Taktsignalen mit einer Phasenlage von 0° und +90° Taktsignale mit einer Phasenlage von 0° und -90° auf. Diese zwei unterschiedlichen "Typen" von Oszillatorringen weisen dann auch einen unterschiedlichen Wert für das Phasenrauschen auf. Somit sind die Oszillatorringe mit parallel gekoppelten Oszillatorstufen zum Erzeugen zweier Taktsignale mit einer festen vorher bestimmbaren Phasenlage nicht ohne Probleme einsetzbar.

Zusätzlich weisen die Vorrichtungen gemäß dem Stand der Technik eine insgesamt komplizierte Verschaltung auf.

Ferner ist aus [9] ein Signalerzeuger für eine variable Frequenz bekannt, welcher als spannungsgesteuerter Oszillator-Schaltkreis ausgebildet ist und welcher Breitband und/oder Multiband Frequenzausgabefunktion aufweist und zwei Steuerspannungen verwendet.

Aus [10] ist ein Schaltkreis und ein Verfahren bekannt, welches in LC oder Ringoszillatoren verwendet wird, wobei die Frequenz der Oszillation mittels Detektierens eines Quadratursignals und mittels Steuerns des Vorzeichens und der Stärke des Quadratursignals moduliert wird.

Aus [11] ist ein Oszillator-Schaltkreis bekannt, in welchem erreicht wird, dass ein oszillierendes Signal zu der Phase eines Eingangssignals, welches an das oszillierende Signal gekoppelt ist, hin phasenverschoben wird.

Der Erfindung liegt somit das Problem zugrunde, einen Injection-Locked-Oscillator-Schaltkreis zu schaffen, der eine vereinfachte Verschaltung, ein gleichmäßigeres Phasenrauschen und dessen Ausgangssignale eine feste Phasenlage zueinander aufweisen.

Das Problem wird gelöst durch einen Injection-Locked-Oscillator-Schaltkreis mit den Merkmalen gemäß dem unabhängigen Patentanspruch.

Ein erfindungsgemäßer Injection-Locked-Oscillator-Schaltkreis weist mindestens zwei Oszillatorstufen auf, wobei jede Oszillatorstufe eine Induktivität, eine Kapazität, mindestens einen Ausgangsknoten, einen Kopplungs-Schaltelement-Teilschaltkreis mit mindestens einem Kopplungs-Schaltelement, wobei die Induktivität und die Kapazität parallel geschaltet sind und wobei der Kopplungs-Schaltelement-Teilschaltkreis, welcher derart parallel zu der Induktivität und der Kapazität gekoppelt ist, dass seriell jeweils genau ein Kopplungs-Schaltelement vorhanden ist und mindestens einen Eingangsanschluss aufweist, welcher mittels des Steueranschlusses des Kopplungs-Schaltelements gebildet ist, wobei die Oszillatorstufen des Injection-Locked-Oscillator-Schaltkreises mittels des Kopplungs-Schaltelement-Teilschaltkreis gekoppelt sind.

Der erfindungsgemäße Injection-Locked-Oscillator-Schaltkreis weist gegenüber dem Stand der Technik den Vorteil auf, dass er ein identisches und, im Vergleich zu einer einstufigen Struktur immer verringertes, Phasenrauschen für die Taktsignale der beiden möglichen Phasenlagen von +90° und - 90° erzielt, wobei das Phasenrauschen identisch mit dem niedrigsten Phasenrauschen der beiden Phasenrauschen des Injection-Locked-Oscillator-Schaltkreis gemäß der in [6] gezeigten Topologie ist.

Anschaulich besteht die erfinderische Idee darin, dass mindestens zwei Oszillatorstufen, auch Oszillator-Teilschaltungen genannt, mittels "Injection Locking" zu einem vollsymmetrischen Quadraturoszillator, d.h. zu einem vollsymmetrischen Injection-Locked-Oscillator-Schaltkreis auch ILO-Schaltkreis genannt, verkoppelt werden, wobei ein Kopplungs-Teilschaltkreis parallel zu der Induktivität und der Kapazität jeder einzelnen Oszillatorstufe geschaltet wird. Wobei innerhalb des Kopplungs-Teilschaltkreises immer nur Reihenschaltungen eines einzelnen Kopplungs-Schaltelements ausgebildet sind, d.h. innerhalb des Kopplungs-Teilschaltkreises gibt es keine seriell geschaltet Kopplungs-Schaltelemente, es können aber mehrere parallel geschaltete Kopplungs-Schaltelemente ausgebildet sein.

In der erfindungsgemäßen vollsymmetrischen Anordnung zweier Quadraturoszillatoren, d.h. die Oszillatorstufen synchronisieren sich die beiden Quadraturoszillatoren, dadurch kommt es zu einen saubereren Nulldurchgang, d.h. zu einem geringeren Schwankungen (Jitter) unterworfenen Nulldurchgang der Taktsignale. Ein saubererer Nulldurchgang bedeutet im Phasenraum wiederum weniger Rauschen. Somit führt die erfindungsgemäße wechselseitige Synchronisation der beiden Oszillator-Teilschaltkreise zu einer Verringerung des Phasenrauschens.

Vorzugsweise weist jede Oszillatorstufe genau zwei Ausgangsanschlüsse auf, an welchen Signale anliegen, welche differentiell zueinander sind.

D.h. an einem ersten Ausgangsanschluss jeder Oszillatorstufe liegt ein Signal an, welches differentiell zu einem Signal ist, welches am zweiten Ausgangssignal anliegt.

In einer Weiterbildung weist der Kopplungs-Schaltelemente-Teilschaltkreis zwei zusätzliche miteinander verschaltete Kopplungs-Schaltelemente auf, welche jeweils parallel zu den miteinander verschalteten Kopplungs-Schaltelementen geschaltet sind.

Die Anordnung von jeweils zwei parallelgeschalteten Kopplungs-Schaltelementen, welche als ein Paar von Kopplungs-Schaltelementen angesehen werden können, verringert den Widerstand der Schaltung im An-Zustand, was wiederum zu einem symmetrischeren ILO-Schaltkreis führt.

Vorzugsweise sind die Kopplungs-Schaltelemente Transistoren.

Die Transistoren können NMOS- und/oder PMOS-Transistoren sind.

PMOS-Transistoren weisen der Vorteil auf, dass sie eine geringe so genannte "Flickernoise" aufweisen, was zu einem geringen Phasenrauschen führt. Allgemein können die Transistoren alle Arten von CMOS-Transistoren sein. Anstelle von CMOS-Transistoren können auch so genannte SOI-Transistoren verwendet werden, d.h. Transistoren, welche auf einem SOI Substrat ausgebildet werden.

Vorzugsweise ist jeweils einer der parallel geschalteten Transistoren ein PMOS-Transistor und der andere parallel geschaltete Transistor ein NMOS-Transistor.

Speziell in der Anordnung von jeweils zwei parallelgeschalteten Transistoren, welche als ein Paar von Transistoren angesehen werden können, bei dem einer der Transistoren eines Paares als PMOS-Transistor und der andere des Paares als NMOS-Transistor ausgebildet ist, verringert den Widerstand der Schaltung im An-Zustand. Ferner können beide Halbphasen eines Wechselspannungs-Taktsignals verwendet werden, was zu einem symmetrischeren Schaltkreis führt.

In einer Weiterbildung sind die Kapazitäten mittels Varaktoren ausgebildet.

Durch das Verwenden von Varaktoren als Kapazitäten ist es möglich variable Kapazitäten in dem ILO-Schaltkreis bereitzustellen, was zu einer verbesserten Abstimmbarkeit der Frequenz des ILO-Schaltkreises führt. Die Varaktoren können beispielsweise mittels Transistoren oder Dioden ausgebildet sein.

Vorzugsweise werden eine gerade Anzahl von Oszillatorstufen zu einem Injection-Locked-Oscillator-Schaltkreis gekoppelt.

Bei einer Verwendung von einer geraden Anzahl von Oszillatorstufen, welche zu einem ILO-Schaltkreis gekoppelt werden, ist die Kopplung besonders einfach und symmetrisch, da identisch aufgebaute Oszillatorstufen verwendet werden können.

Die Anzahl der Eingangsanschlüsse jeder Oszillatorstufe kann gleich der Anzahl von Oszillatorstufen des Injection-Locked-Oscillator-Schaltkreises sein.

Werden Oszillatorstufen mit einer Anzahl von Eingangsanschlüssen, die gleich der Anzahl der Oszillatorstufen ist verwendet, ergibt sich für den Fall von differentiellen Ausgangsanschlüssen der Oszillatorstufen, dass jede Oszillatorstufe mit allen anderen Oszillatorstufen gekoppelt, d.h. synchronisiert, werden kann, welche eine passende Phasenlage aufweisen. Hierdurch verbessert sich die Synchronisierung und das Phasenrauschen kann weiter gesenkt werden.

In einer bevorzugten Weiterbildung weist der Injection-Locked-Oscillator-Schaltkreis vier Oszillatorstufen auf, wobei jede Oszillatorstufe genau vier Eingangsanschlüsse und genau zwei Ausgangsanschlüsse aufweist und wobei zwei der Eingangsanschlüsse mit den Ausgangsanschlüssen einer vorangehenden Oszillatorstufe des Injection-Locked-Oscillator-Schaltkreises gekoppelt sind und die anderen beiden Eingangsanschlüsse mit den Ausgangsanschlüssen der nachfolgenden Injection-Locked-Oscillator-Schaltkreises gekoppelt sind.

Mittels der Verwendung von vier Oszillatorstufen innerhalb eines ILO-Schaltkreises kann die Synchronisierung verstärkt werden und damit das Phasenrauschen zusätzlich reduziert werden. Jede Oszillatorstufe des ILO-Schaltkreises aus vier Oszillatorstufen wird sowohl mit der nachfolgenden als auch mit der vorangehenden Oszillatorstufe synchronisiert. Die Phasenverschiebung der Signale, welche an den Ausgangsanschlüssen anliegen, beträgt hierbei von einer zur nachfolgenden Oszillatorstufe innerhalb des ILO-Schaltkreises immer 90°. Die Kopplung der einzelnen Oszillatorstufen wird mittels der so genannten "Tank-Lock" Kopplung durchgeführt, d.h. die Kopplung erfolgt direkt über den Tank der Oszillatorstufe.

Vorzugsweise weisen die Oszillatorstufen des Injection-Locked-Oscillator-Schaltkreises ein aktives Element auf.

Ein solches aktives Element kann beispielsweise mittels einer Tunneldiode oder mittels Transistoren ausgebildet sein.

In einer Weiterbildung des Injection-Locked-Oscillator-Schaltkreis weist der Injection-Locked-Oscillator-Schaltkreis eine ungerade Anzahl von Oszillatorstufen auf.

Allgemein kann gesagt werden, dass bei einem Oszillatorring mit k-Oszillatorstufen die n-te Oszillatorstufen mit den Ausgangsanschlüssen von allen mod(n+x;k) Oszillatorstufen gekoppelt ist, wobei x alle ungeraden Zahlen von 1 bis k durchläuft, oder mathematisch ausgedrückt *x* = {*x* |mod(*x*+1;2) = 0} , wobei "mod" die Modulofunktion darstellt. D.h. das jede gegebene Oszillatorstufe immer mit allen Oszillatorstufen gekoppelt ist, welche Phasenverschiebungen von 90° zu der gegebenen Oszillatorstufe aufweisen.

Ein Vorteil der erfindungsgemäßen Oszillatorstufen ist, dass aufgrund der Wirkungsweise der Koppeltransistoren nicht auf die Phasenlage der Signale in den Zweigen geachtet werden muss, welche der Rückkopplung einer Oszillatorstufen dienen. D.h. Kreuzkopplung und direkte Kopplung der einzelnen Oszillatorstufen untereinander liefern das gleiche Ergebnis.

Durch erfindungsgemäße Kopplung entsteht eine Synchronisierung der Nulldurchgänge einer Oszillatorstufe mit den Minima/Maxima der vorangehenden Oszillatorstufe. Diese Synchronisation sorgt dafür, dass zeitliche Variationen (Jitter) in den Nulldurchgängen reduziert werden, was gleichbedeutend mit geringeren Phasenrauschen ist.

Bei der Verwendung von mehr als zwei Oszillatorstufen innerhalb eines ILO-Schaltkreises kann die Synchronisierung verstärkt werden und damit das Phasenrauschen zusätzlich reduziert werden. So wird bei einem ILO-Schaltkreis aus vier Oszillatorstufen jede Oszillatorstufe sowohl mit der nachfolgenden als auch mit der vorangehenden Oszillatorstufe synchronisiert.

Zu einem erfindungsgemäßen ILO-Schaltkreis ist ferner anzumerken, dass die Kopplung der einzelnen Oszillatorstufen direkt über den Tank der Oszillatorstufe durchgeführt wird und ferner die Ausgestaltung der einzelnen Oszillatorstufen des ILO-Schaltkreises von der Anzahl der Oszillatorstufen innerhalb des ILO-Schaltkreises abhängt. Insbesondere sind bei einer geraden Anzahl von Oszillatorstufen innerhalb des ILO-Schaltkreises die Anzahl der Eingangsanschlüsse, gleich der Anzahl der Oszillatorstufen.

Für die Koppeltransistoren in der betrachteten Realisierung wurden vorzugsweise PMOS-Transistoren verwendet, weil PMOS-Transistoren eine geringere so genannte "Flickernoise" aufweisen als NMOS-Transistoren. Es ist jedoch auch möglich NMOS-Transistoren zu verwenden. Prinzipiell ist es auch möglich die Kopplung mit nur einen Transistor pro rückkoppelnder Stufe durchzuführen.

Es ist auch möglich ein Schaltelement durch ein Transferelement zu ersetzen, bzw. statt PMOS-Transistoren nur NMOS-Transistoren zu verwenden. Erfindungsgemäß ist es auch möglich SOI-Transitoren, d.h. Transistoren, welche auf einem SOI Substrat ausgebildet werden, zu verwenden.

Ausführungsbeispiele der Erfindung sind in den Figuren dargestellt und werden im Weiteren näher erläutert.

Es zeigen:
- Figur 1: eine schematische Darstellung einer Schaltungsanordnung eines Injection-Locked-Oscillator-Schaltkreis gemäß einem ersten Ausführungsbeispiel der Erfindung;
- Figur 2: eine schematische Darstellung einer Schaltungsanordnung eines Injection-Locked-Oscillator-Schaltkreis aus Fig. 1 mit einen zusätzlichen Paar von Koppeltransistoren;
- Figur 3: schematische Darstellung dreier Schaltungsanordnungen 3a, 3b und 3c von erfindungsgemäßen Injection-Locked-Oscillator-Schaltkreisen;
- Figur 4: eine schematische Darstellung einer erfindungsgemäßen Oszillatorstufe, welche bei einem Injection-Locked-Oscillator-Schaltkreis aus zwei Oszillatorstufen verwendet werden kann;
- Figur 5: schematische Darstellungen zweier erfindungsgemäßen Oszillatorstufen 5a und 5b, welche bei Injection-Locked-Oscillator-Schaltkreisen aus vier bzw. sechs Oszillatorstufen verwendet werden können;
- Figur 6: eine schematische Darstellung der Kopplung vierer Oszillatorstufen zu einem Injection-Locked-Oscillator-Schaltkreis aus vier Oszillatorstufen;
- Figur 7: Ergebnisse einer Simulationsrechnung über Phasenrauschen von Injection-Locked-Oscillator-Schaltkreisen;
- Figur 8: Ergebnisse einer Simulationsrechnung über Phasenrauschen von Injection-Locked-Oscillator-Schaltkreisen;
- Figur 9: eine schematische Darstellung der Kopplung dreier Oszillatorstufen zu einem Injection-Locked-Oscillator-Schaltkreis aus einer ungeraden Anzahl von Oszillatorstufen;
- Figur 10: eine schematische Darstellung eines differenziellen Oszillators gemäß dem Stand der Technik;
- Figur 11: eine symbolische Darstellung einer Oszillatorstufe gemäß dem Stand der Technik;
- Figur 12: eine schematische Darstellung der Kopplung mehrerer Oszillatorstufen gemäß dem Stand der Technik;
- Figur 13: eine schematische Darstellung einer Oszillatorstufe für eine serielle Kopplung gemäß dem Stand der Technik; und ,
- Figur 14: eine schematische Darstellung einer Oszillatorstufe für eine parallele Kopplung gemäß dem Stand der Technik.

In den Figuren bezeichnen gleiche oder ähnliche Bezugsziffern in unterschiedlichen Figuren gleiche oder ähnliche Komponente. In den Ausführungsbeispielen der Erfindung sind überwiegend CMOS-Transistoren in den Figuren dargestellt und beschrieben, es können jedoch als Transistoren auch SOI-Transistoren, d.h. Transistoren, welche mittels eines SOI-Substrats ausgebildet werden, verwendet werden. Auch ist die in den Ausführungsbeispielen erläuterte Kopplung von Bulk-Anschlüsse von Transistoren nur beispielhaft zu sehen. Erfindungsgemäß können die Bulk-Anschlüsse der Transistoren außer mit einer Versorgungsspannung beispielsweise auch mit einem Mittenpotential, einer Bezugsspannungsquelle, mit Masse und/oder mit dem Source-Anschluss gekoppelt sein. Auch können die Bulk-Anschlüsse "floatend", d.h. unangeschlossen, betrieben werden. Insbesondere werden z.B. bei SOI-Transistoren im Allgemeinen keine Bulk-Anschlüsse verwendet.

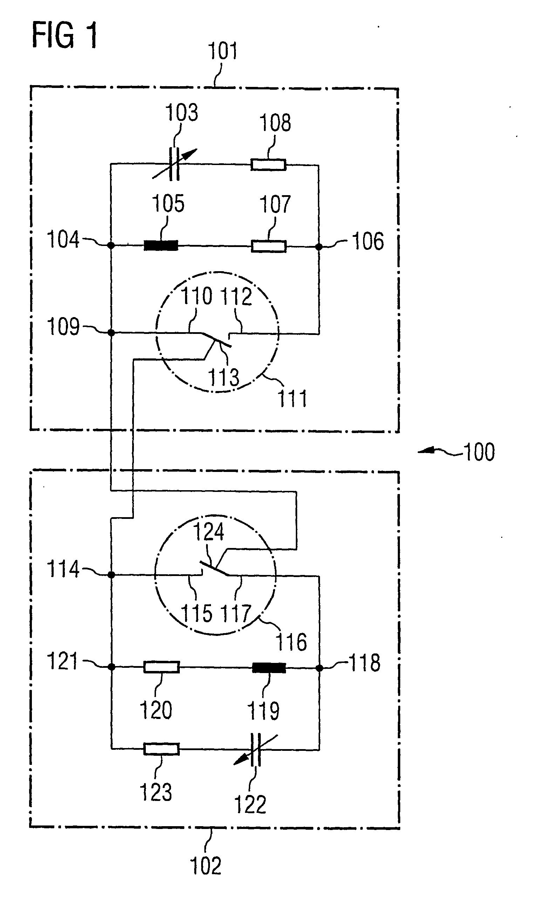

Im Weiteren wird bezugnehmend auf **Fig.1** ein Injection-Locked-Oscillator-Schaltkreis 100, im Weiteren auch als ILO-Schaltkreis 100 bezeichnet, gemäß einem ersten Ausführungsbeispiel der Erfindung beschrieben.

Der ILO-Schaltkreis 100 weist zwei Oszillatorstufen 101 und 102 auf. Der ILO-Schaltkreis 100 weist eine erste Kapazität 103 auf. Ein erster Anschluss der ersten Kapazität 103 ist mit einem ersten Knoten 104 gekoppelt. Der erste Knoten 104 ist mit einem ersten Anschluss einer ersten Induktivität 105 gekoppelt. Der zweite Anschluss der ersten Induktivität 105 ist mit einem zweiten Knoten 106 gekoppelt. In Fig. 1 ist zusätzlich zur Induktivität auch deren Widerstand mit einem Widerstand 107 eingezeichnet, dieser ist jedoch nicht als separater Widerstand zu verstehen, sondern stellt den Widerstand der ersten Induktivität 105 dar. Der zweite Knoten 106 ist mit dem zweiten Anschluss der ersten Kapazität 103 gekoppelt. Auch für die erste Kapazität ist in Fig. 1 der Ersatzwiderstand als eigenes Symbol 108 eingezeichnet.

Ferner ist der erste Knoten 104 mit einem dritten Knoten 109 gekoppelt. Der dritte Knoten 109 ist mit einem ersten Source/Drain-Anschluss 110 eines ersten Transistors 111 gekoppelt. Der zweite Source/Drain-Anschluss 112 des ersten Transistors 111 ist mit dem zweiten Knoten 106 gekoppelt.

Der Gateanschluss 113 des ersten Transistors 111 ist mit einem vierten Knoten 114 gekoppelt. Der vierte Knoten 114 ist mit einem ersten Source/Drain-Anschluss 115 eines zweiten Transistors 116 gekoppelt. Der zweite Source/Drain-Anschluss 117 des zweiten Transistors 116 ist mit dem fünften Knoten 118 gekoppelt. Der fünfte Knoten 118 ist mit einem ersten Anschluss einer zweiten Induktivität 119 gekoppelt. Auch für die zweite Induktivität 119 ist in Fig. 1 der Ersatzwiderstand als eigenes Symbol 120 eingezeichnet. Der zweite Anschluss der zweiten Induktivität 119 ist mit einem sechsten Knoten 121 gekoppelt. Der sechste Knoten 121 ist mit dem vierten Knoten 114 gekoppelt. Ferner ist der sechste Knoten 121 mit einem ersten Anschluss einer zweiten Kapazität 122 gekoppelt. Der zweite Anschluss der zweiten Kapazität 122 ist mit dem fünften Knoten 118 gekoppelt. Auch für die zweite Kapazität 122 ist in Fig. 1 der Ersatzwiderstand als eigenes Symbol 123 eingezeichnet. Ferner ist der Gateanschluss 124 des zweiten Transistors 116 mit dem dritten Knoten 109 gekoppelt.

Somit ist der gesamte erfindungsgemäße ILO-Schaltkreis beschreiben. Die erste Kapazität 103, die erste Induktivität 105 und der erste Transistor 111 bilden zusammen die erste Oszillatorstufe 101 aus. Die zweite Kapazität 122, die zweite Induktivität 119 und der zweite Transistor 116 bilden zusammen die zweite Oszillatorstufe 102 aus. Die erste und zweite Oszillatorstufen sind mittels der beiden Transistoren gekoppelt, weswegen die Transistoren 111 und 116 auch als Koppeltransistoren bezeichnet werden. Die erste und zweite Kapazität können als so genannte Varaktoren, d.h. als variable Kapazitäten, ausgebildet sein. Die Varaktoren können beispielsweise mittels Transistoren oder Dioden ausgebildet sein.

In der oben beschriebenen erfindungsgemäßen vollsymmetrischen Anordnung zweier Oszillatorstufen, welche auch als Quadraturoszillatoren bezeichnet werden, synchronisieren sich die beiden Quadraturoszillatoren, wodurch es zu einen saubereren Nulldurchgang, d.h. zu einem geringeren Schwankungen (Jitter) unterworfenen Nulldurchgang, der Taktsignale kommt. Dieses gegenseitige Synchronisieren wird als Injection-Locking bezeichnet. Ein saubererer Nulldurchgang bedeutet im Phasenraum wiederum weniger Rauschen. Somit führt die erfindungsgemäße wechselseitige Synchronisation der beiden Oszillatorstufen zu einer Verringerung des Phasenrauschens.

Ein Abgriff des Quadratursignals des ILO-Schaltkreises 100 für eine I/Q-(De)Modulation ist zum Beispiel an dem zweiten Knoten 106 möglich.

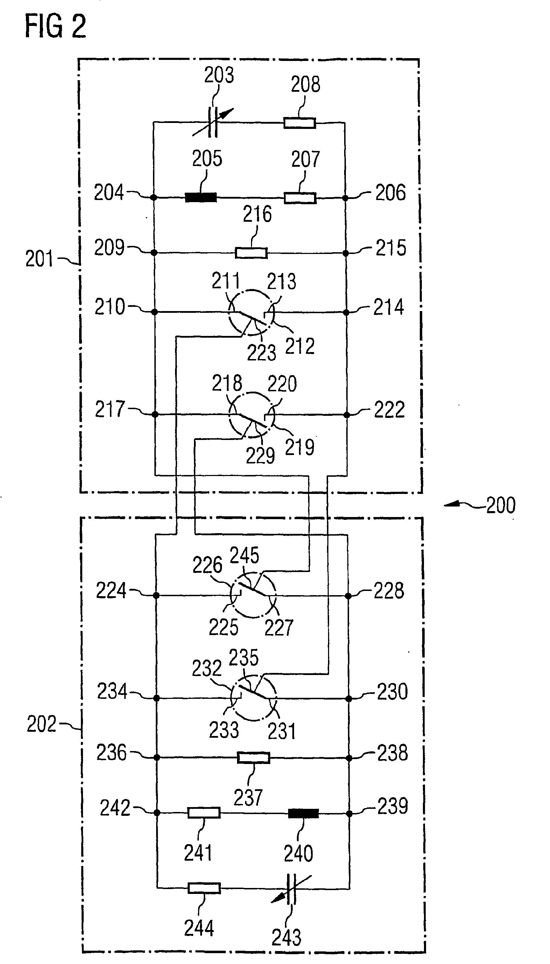

Im Weiteren wird bezugnehmend auf **Fig.2** ein Injection-Locked-Oscillator-Schaltkreis 200 beschrieben, welcher gegenüber dem Ausführungsbeispiel der Fig. 1 dahin gehend abgewandelt ist, dass er je Oszillatorstufe einen zweiten Transistor aufweist. Somit weist der ILO-Schaltkreis 200 zwei Transistorenpaare auf, wobei die Transistoren eines Paares, d.h. einer Oszillatorstufe zueinander parallelgeschaltet sind. Zusätzlich weist jede der Oszillatorstufen des in Fig. 2 dargestellten ILO-Schaltkreises 200 auch noch einen "negativen Widerstand", d.h. ein aktives Element, auf, welches beispielsweise mittels einer Tunneldiode oder mittels Transistoren ausgebildet sein kann.

Der ILO-Schaltkreis 200 weist zwei Oszillatorstufen 201 und 202 auf. Der ILO-Schaltkreis 200 weist eine erste Kapazität 203 auf. Ein erster Anschluss der ersten Kapazität 203 ist mit einem ersten Knoten 204 gekoppelt. Der erste Knoten 204 ist mit einem ersten Anschluss einer ersten Induktivität 205 gekoppelt. Der zweite Anschluss der ersten Induktivität 205 ist mit einem zweiten Knoten 206 gekoppelt. In Fig. 2 ist zusätzlich zur Induktivität auch deren Widerstand mit einem Widerstand 207 eingezeichnet, dieser ist jedoch nicht als separater Widerstand zu verstehen, sondern stellt den Widerstand der ersten Induktivität 205 dar. Der zweite Knoten 206 ist mit dem zweiten Anschluss der ersten Kapazität 203 gekoppelt. Auch für die erste Kapazität ist in Fig. 2 der Ersatzwiderstand als eigenes Symbol 208 eingezeichnet.

Ferner ist der erste Knoten 204 mit einem dritten Knoten 209 gekoppelt. Der dritte Knoten 209 ist mit einem vierten Knoten 210 gekoppelt. Der vierte Knoten 210 ist mit einem ersten Source/Drain-Anschluss 211 eines ersten Transistors 212 gekoppelt. Der zweite Source/Drain-Anschluss 213 des ersten Transistors 212 ist mit einem fünften Knoten 214 gekoppelt. Der fünfte Knoten 214 ist mit einem sechsten Knoten 215 gekoppelt. Der sechste Knoten 215 ist einerseits mit dem zweiten Knoten 206 gekoppelt, andererseits ist der sechste Knoten 215 mit einem ersten Anschluss eines ersten aktiven Elements 216 (negativer Widerstand) gekoppelt. Der zweite Anschluss des ersten aktiven Elements 216 ist mit dem dritten Knoten 209 gekoppelt.

Der vierte Knoten 210 ist ferner mit einem siebten Knoten 217 gekoppelt. Der siebte Knoten 217 ist mit einem ersten Source/Drain-Anschluss 218 eines zweiten Transistors 219 gekoppelt. Der zweite Source/Drain-Anschluss 220 des zweiten Transistors 219 ist mit einem achten Knoten 222 gekoppelt. Der achte Knoten 222 ist mit dem fünften Knoten 214 gekoppelt.

Der Gateanschluss 223 des ersten Transistors 212 ist mit einem neunten Knoten 224 gekoppelt. Der neunte Knoten 224 ist mit einem ersten Source/Drain-Anschluss 225 eines dritten Transistors 226 gekoppelt. Der zweite Source/Drain-Anschluss 227 des dritten Transistors 226 ist mit einem zehnten Knoten 228 gekoppelt. Der zehnte Knoten 228 ist mit dem Gateanschluss 229 des zweiten Transistors 219 gekoppelt. Der Gateanschluss 245 des dritten Transistors 226 ist mit den siebten Knoten 217 gekoppelt.

Der zehnte Knoten 228 ist ferner mit einem elften Knoten 230 gekoppelt. Der elfte Knoten 230 ist mit einem ersten Source/Drain-Anschluss 231 eines vierten Transistors 232 gekoppelt. Der zweite Source/Drain-Anschluss 233 des vierten Transistors 232 ist mit einem zwölften Knoten 234 gekoppelt. Der zwölfte Knoten 234 ist mit dem neunten Knoten 224 gekoppelt. Der Gateanschluss 235 des vierten Transistors 232 ist mit dem achten Knoten 222 gekoppelt.

Der zwölfte Knoten 234 ist ferner mit einem dreizehnten Knoten 236 gekoppelt. Der dreizehnte Knoten 236 ist ferner mit einem ersten Anschluss eines zweiten aktiven Elements 237 gekoppelt. Der zweite Anschluss des zweiten aktiven Elements 237 ist mit einem vierzehnten Knoten 238 gekoppelt. Der vierzehnte Knoten 238 ist mit dem elften Knoten 230 gekoppelt. Ferner ist der vierzehnte Knoten 238 mit einem fünfzehnten Knoten 239 gekoppelt. Der fünfzehnte Knoten 239 ist mit einem ersten Anschluss einer zweiten Induktivität 240 gekoppelt. Auch für die zweite Induktivität 240 ist in Fig. 2 der Ersatzwiderstand als eigenes Symbol 241 eingezeichnet. Der zweite Anschluss der zweiten Induktivität 240 ist mit einem sechzehnten Knoten 242 gekoppelt. Der sechzehnte Knoten 242 ist mit dem dreizehnten Knoten 236 gekoppelt. Ferner ist der sechzehnte Knoten 242 mit einem ersten Anschluss einer zweiten Kapazität 243 gekoppelt. Der zweite Anschluss der zweiten Kapazität 243 ist mit dem fünfzehnten Knoten 239 gekoppelt. Auch für die zweite Kapazität 243 ist in Fig. 2 der Ersatzwiderstand als eigenes Symbol 244 eingezeichnet.

Somit ist der gesamte in Fig. 2 dargestellte ILO-Schaltkreis beschreiben. Die erste Kapazität 203, die erste Induktivität 205, das erste aktive Element 216, der erste Transistor 212 und der zweite Transistor 219 bilden zusammen die erste Oszillatorstufe 201 aus. Die zweite Kapazität 243, die zweite Induktivität 240, das zweite aktive Element 237, der dritte Transistor 226 und der vierte Transistor 232 bilden zusammen die zweite Oszillatorstufe 202 aus. Die erste und zweite Oszillatorstufen sind mittels der vier Transistoren gekoppelt. Diese vier Transistoren stellen wiederum Koppeltransistoren dar. Die erste und zweite Kapazität können als so genannte Varaktoren, d.h. als variable Kapazitäten, ausgebildet sein.

Anzumerken ist ferner, dass auch die in Fig. 1 gezeigte Oszillatorstufe mit einem aktiven Element versehen sein sollte. Das Verwenden eines aktiven Elements führt dazu, dass die Schwingungsamplitude des Signals des Injection-Locked-Oscillator-Schaltkreises nicht verschwindet und stabilisiert wird. Zur Realisierung eines aktiven Elements kann jede bekannte Ausführung, z.B. eine Tunneldiode oder Transistoren, verwendet werden.

Die Transistoren der in Fig. 1 und 2 dargestellten ILO-Schaltkreise sind CMOS-Transistoren. Erfindungsgemäß können auch SOI-Transitoren verwendet werden.

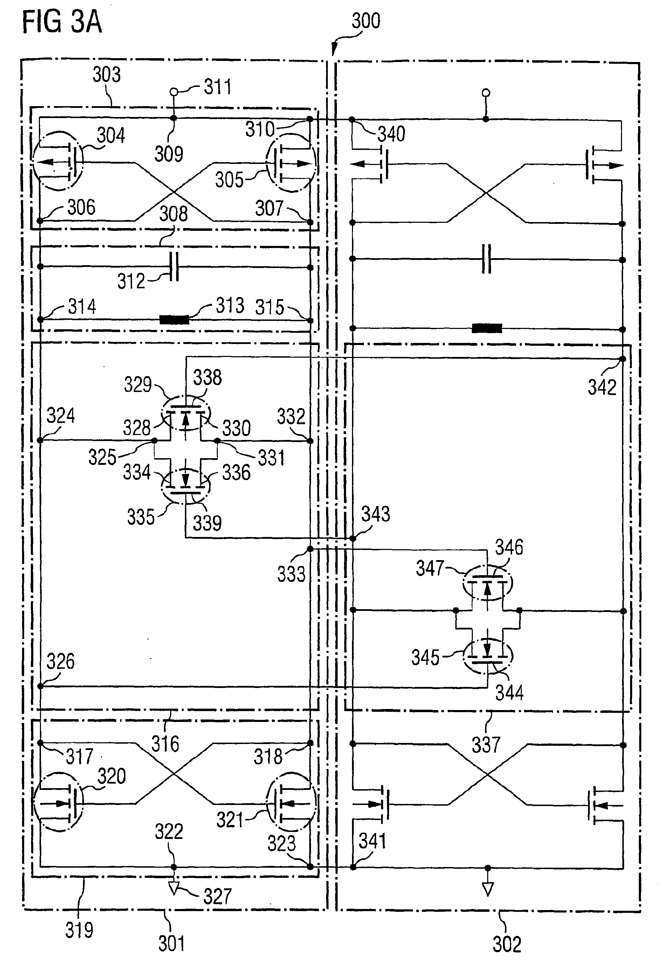

Nachfolgend werden mit Bezug auf Fig. 3a bis 3c Ausführungsbeispiele für drei Injection-Locked-Oscillator-Schaltkreise erläutert.

In **Fig. 3a** ist ein Injection-Locked-Oscillator-Schaltkreis 300 aus zwei Oszillatorstufen 301 und 302 dargestellt. Die erste Oszillatorstufe 301 weist einen ersten Oszillatortransistor-Teilschaltkreis 303 auf. Der erste Oszillatortransistor-Teilschaltkreis 303 weist einen ersten Transistor 304 und einen zweiten Transistor 305 auf, welche kreuzweise miteinander verschaltet sind und wobei der erste Transistor 304 und der zweite Transistor 305 einen Bulk-Anschluss aufweisen. Der erste Oszillatortransistor-Teilschaltkreis 303 ist über einen ersten Knoten 306 und einen zweiten Knoten 307 parallel zu einem LC-Glied 308 der ersten Oszillatorstufe 301 geschaltet. Ferner weist der erste Oszillatortransistor-Teilschaltkreis 303, einen dritten Knoten 309 und einen vierten Knoten 310 auf. Der dritte Knoten 309 ist mit einer Versorgungsspannungsquelle 311 gekoppelt.

Das LC-Glied 308 weist eine Kapazität 312 und eine Induktivität 313 auf, welche parallel verschaltet werden. Das LC-Glied 308 ist ferner mittels eines fünften Knoten 314 und eines sechsten Knotens 315 parallel mit einem Koppeltransistor-Teilschaltkreis 316 gekoppelt.

Der Koppeltransistor-Teilschaltkreis 316 wird nachfolgend ausführlicher beschreiben werden. Ferner ist der Koppeltransistor-Teilschaltkreis 316 mittels eines siebten Knotens 317 und eines achten Knotens 318 an einen zweiten Oszillatortransistor-Teilschaltkreis 319 gekoppelt.

Der zweite Oszillatortransistor-Teilschaltkreis 319 weist einen dritten Transistor 320 und einen vierten Transistor 321 auf, welche kreuzweise miteinander verschaltet sind und wobei der dritte Transistor 320 und der vierte Transistor 321 einen Bulk-Anschluss aufweisen. Ferner weist der zweite Oszillatortransistor-Teilschaltkreis 319, einen neunten Knoten 322 und einen zehnten Knoten 323 auf. Der neunte Knoten 322 ist mit einer Bezugsspannungsquelle 327 gekoppelt.

Im Weiteren wird der Koppeltransistor-Teilschaltkreis 316, welcher prinzipiell mittels zweier parallel geschalteter Transistoren gebildet ist, detailliert beschrieben. Der Koppeltransistor-Teilschaltkreis 316 weist einen elften Knoten 324 auf, welcher mit dem fünften Knoten 314 gekoppelt ist. Ferner ist der elfte Knoten mit einem zwölften Knoten 325 und mit einem dreizehnten Knoten 326 gekoppelt. Der dreizehnte Knoten 326 ist mit dem siebten Knoten 317 gekoppelt. Der zwölfte Knoten 325 ist mit einem ersten Source/Drain-Anschluss 328 eines fünften Transistors 329 gekoppelt. Der zweite Source/Drain-Anschluss 330 des fünften Transistors 329 ist mit einem vierzehnten Knoten 331 gekoppelt. Der vierzehnte Knoten 331 ist mit einem fünfzehnten Knoten gekoppelt 332, welcher an den sechsten Knoten 315 gekoppelt ist. Ferner ist der fünfzehnte Knoten 332 mit einen sechzehnten Knoten 333 gekoppelt, welcher mit dem achten Knoten 318 gekoppelt ist.

Der zwölfte Knoten 325 ist ferner mit einem ersten Source/Drain-Anschluss 334 eines sechsten Transistors 335 gekoppelt. Der zweite Source/Drain-Anschluss 336 des sechsten Transistors 335 ist mit dem vierzehnten Knoten 331 gekoppelt.

Der fünfte Transistor 329 und der sechste Transistor 335 sind im Ausführungsbeispiel NMOS-Transistoren mit einem Bulk-Anschluss. Es können jedoch auch PMOS-Transistoren mit Bulk-Anschluss sein.

Im Ausführungsbeispiel bilden die bisher beschriebenen Elemente die erste Oszillatorstufe 301 des ILO-Schaltkreises 300. Die zweite Oszillatorstufe 302 des ILO-Schaltkreises 300 ist baugleich mit der ersten Oszillatorstufe 301. Deshalb wird nachfolgend nur die Kopplung der beiden Oszillatorstufen näher beschrieben. Zu beachten ist, dass in Fig. 3a der Koppeltransistor-Teilschaltkreis 337 der zweiten Oszillatorstufe 302 gegenüber dem Koppeltransistor-Teilschaltkreis 316 der ersten Oszillatorstufe 301 anschaulich um 180° gedreht ist.

Der Kopplung der beiden Oszillatorstufen dienen der vierte Knoten 310, der zehnte Knoten 323, der dreizehnte Knoten 326, der sechzehnte Knoten 333, der Gateanschluss 338 des fünften Transistors 329 und der Gateanschluss 339 des sechsten Transistors 335.

Die Kopplung der beiden Oszillatorstufen ist wie folgt:
Der vierte Knoten 310 der ersten Oszillatorstufe 301 ist mit dem vierten Knoten 340 der zweiten Oszillatorstufe 302 gekoppelt.
Der zehnte Knoten 323 der ersten Oszillatorstufe 301 ist mit dem zehnten Knoten 341 der zweiten Oszillatorstufe 302. gekoppelt.
Der Gateanschluss 338 des fünften Transistors 329 der ersten Oszillatorstufe 301 ist mit dem dreizehnten Knoten 342 der zweiten Oszillatorstufe 302 gekoppelt.
Der Gateanschluss 339 des sechsten Transistors 335 der ersten Oszillatorstufe 301 ist mit dem sechzehnten Knoten 343 der zweiten Oszillatorstufe 302 gekoppelt.
Der dreizehnte Knoten 326 der ersten Oszillatorstufe 301 ist mit dem Gateanschluss 344 des fünften Transistors 345 der zweiten Oszillatorstufe 302 gekoppelt.
Der sechzehnte Knoten 333 der ersten Oszillatorstufe 301 ist mit dem Gateanschluss 346 des sechsten Transistors 347 der zweiten Oszillatorstufe 302 gekoppelt.

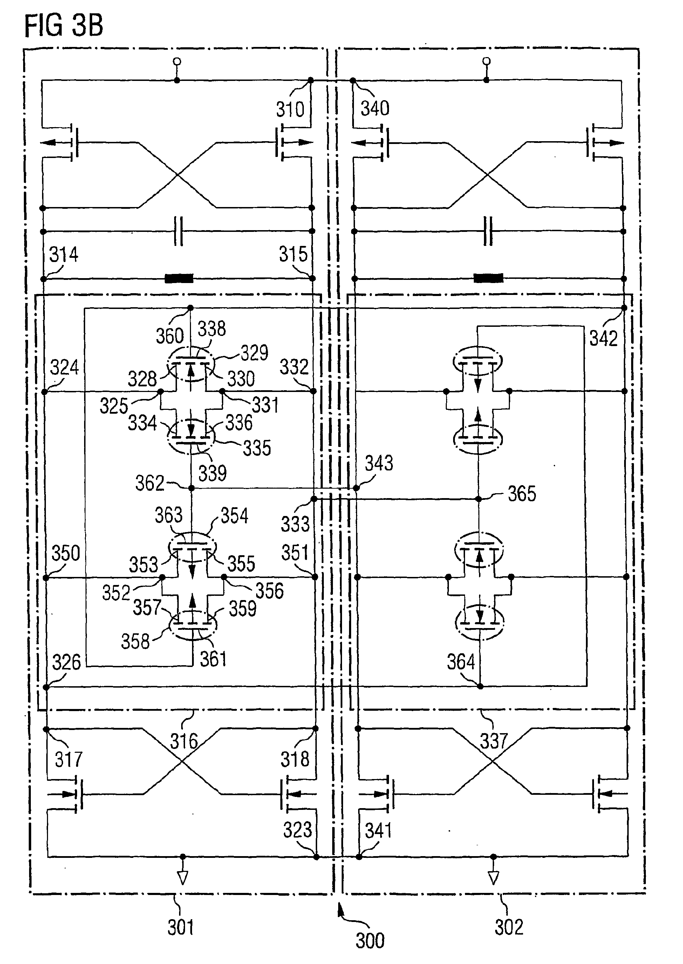

Bezugnehmend auf die **Fig. 3b** wird nachfolgend ein anderes Ausführungsbeispiel eines Injection-Locked-Oscillator-Schaltkreises beschrieben, welcher sich von dem in Fig. 3a gezeigten dadurch unterscheidet, dass der Koppeltransistor-Teilschaltkreis der Oszillatorstufen jeweils vier Transistoren aufweist.

Da sich in Fig. 3b nur der Koppeltransistor-Teilschaltkreis einer Oszillatorstufe von der Oszillatorstufe aus Fig. 3a unterscheidet, wird nur der Koppeltransistor-Teilschaltkreis 316 genauer beschrieben, und gleiche oder ähnliche Bezeichnungen und Bezugszeichen verweisen auf gleiche oder ähnliche Bauteile.

Der Koppeltransistor-Teilschaltkreis 316 weist einen elften Knoten 324 auf, welcher mit einem fünften Knoten 314 gekoppelt ist. Ferner ist der elfte Knoten mit einem zwölften Knoten 325 und mit einem siebzehnten Knoten 350 gekoppelt. Der siebzehnte Knoten 350 ist mit dem dreizehnten Knoten 326 gekoppelt. Der dreizehnte Knoten 326 ist mit einem siebten Knoten 317 gekoppelt.

Der zwölfte Knoten 325 ist mit einem ersten Source/Drain-Anschluss 328 eines fünften Transistors 329 gekoppelt. Der zweite Source/Drain-Anschluss 330 des fünften Transistors 329 ist mit einem vierzehnten Knoten 331 gekoppelt. Der vierzehnte Knoten 331 ist mit einem fünfzehnten Knoten gekoppelt 332, welcher an einen sechsten Knoten 315 gekoppelt ist. Ferner ist der fünfzehnte Knoten 332 mit einem sechzehnten Knoten 333 gekoppelt, welcher mit einem achtzehnten Knoten 351 gekoppelt ist, welcher wiederum mit einem achten Knoten 318 gekoppelt ist.

Der zwölfte Knoten 325 ist ferner mit einem ersten Source/Drain-Anschluss 334 eines sechsten Transistors 335 gekoppelt. Der zweite Source/Drain-Anschluss 336 des sechsten Transistors 335 ist mit dem vierzehnten Knoten 331 gekoppelt.

Der fünfte Transistor 329 und der sechste Transistor 335 sind im Ausführungsbeispiel NMOS-Transistoren mit einem Bulk-Anschluss. Es können jedoch auch PMOS-Transistoren mit Bulk-Anschluss sein.

Der siebzehnte Knoten 350 ist mit einem neunzehnten Knoten 352 gekoppelt. Der neunzehnte Knoten 352 ist mit einem ersten Source/Drain-Anschluss 353 eines siebten Transistors 354 gekoppelt. Der zweite Source/Drain-Anschluss 355 des siebten Transistors 354 ist mit einem zwanzigsten Knoten 356 gekoppelt. Der zwanzigsten Knoten 356 ist mit dem achtzehnten Knoten 351 gekoppelt.

Der neunzehnte Knoten 352 ist ferner mit einem ersten Source/Drain-Anschluss 357 eines achten Transistors 358 gekoppelt. Der zweite Source/Drain-Anschluss 359 des achten Transistors 358 ist mit dem zwanzigsten Knoten 356 gekoppelt.

Der siebte Transistor 354 und der achte Transistor 358 sind im Ausführungsbeispiel PMOS-Transistoren mit einem Bulk-Anschluss. Es können jedoch auch NMOS-Transistoren mit Bulk-Anschluss sein. Zu beachten ist jedoch, dass sie vorzugsweise vom entgegengesetzen Typ sind wie der fünfte und der sechste Transistor, d.h. wenn der fünfte und sechste Transistor PMOS-Transistoren sind, dann sind der siebte und der achte Transistor vorzugsweise NMOS-Transistoren.

Der Gateanschluss 338 des fünften Transistors 329 ist mit einem einundzwanzigsten Knoten 360 gekoppelt, welcher mit dem Gateanschluss 361 des achten Transistors 358 gekoppelt ist. Der Gateanschluss 339 des sechsten Transistors 335 ist mit einem zweiundzwanzigsten Knoten 362 gekoppelt, welcher mit dem Gateanschluss 363 des siebten Transistors 354 gekoppelt ist.

Im Ausführungsbeispiel der Fig. 3b bilden die bisher beschriebenen Elemente den Koppeltransistor-Teilschaltkreis 316 der ersten Oszillatorstufe 301 des Injection-Locked-Oscillator-Schaltkreises 300. Die sonstigen Elemente der ersten Oszillatorstufe 301 sind identisch zu den Elementen der in Fig. 3a dargestellten Oszillatorstufe. Die zweite Oszillatorstufe 302 des Injection-Locked-Oscillator-Schaltkreises 300 ist baugleich mit der ersten Oszillatorstufe 301. Deshalb wird nachfolgend nur die Kopplung der beiden Oszillatorstufen näher beschrieben. Zu beachten ist, dass in Fig. 3b der Koppeltransistor-Teilschaltkreis 337 der zweiten Oszillatorstufe 302 gegenüber dem Koppeltransistor-Teilschaltkreis 316 der ersten Oszillatorstufe 301 anschaulich um 180° gedreht ist.

Der Kopplung der beiden Oszillatorstufen dienen der vierte Knoten 310, der zehnte Knoten 323, der dreizehnte Knoten 326, der sechzehnte Knoten 333, der einundzwanzigste Knoten 360 und der zweiundzwanzigste Knoten 362.

Die Kopplung der beiden Oszillatorstufen ist wie folgt:
Der vierte Knoten 310 der ersten Oszillatorstufe 301 ist mit dem vierten Knoten 340 der zweiten Oszillatorstufe 302 gekoppelt.
Der zehnte Knoten 323 der ersten Oszillatorstufe 301 ist mit dem zehnten Knoten 341 der zweiten Oszillatorstufe 302 gekoppelt.
Der einundzwanzigsten Knoten 360 der ersten Oszillatorstufe 301 ist mit dem dreizehnten Knoten 342 der zweiten Oszillatorstufe 302 gekoppelt.
Der zweiundzwanzigsten Knoten 362 der ersten Oszillatorstufe 301 ist mit dem sechzehnten Knoten 343 der zweiten Oszillatorstufe 302 gekoppelt.
Der dreizehnte Knoten 326 der ersten Oszillatorstufe 301 ist mit dem einundzwanzigsten Knoten 364 der zweiten Oszillatorstufe 302 gekoppelt.
Der sechzehnte Knoten 333 der ersten Oszillatorstufe 301 ist mit dem zweiundzwänzigsten Knoten 365 der zweiten Oszillatorstufe 302 gekoppelt.

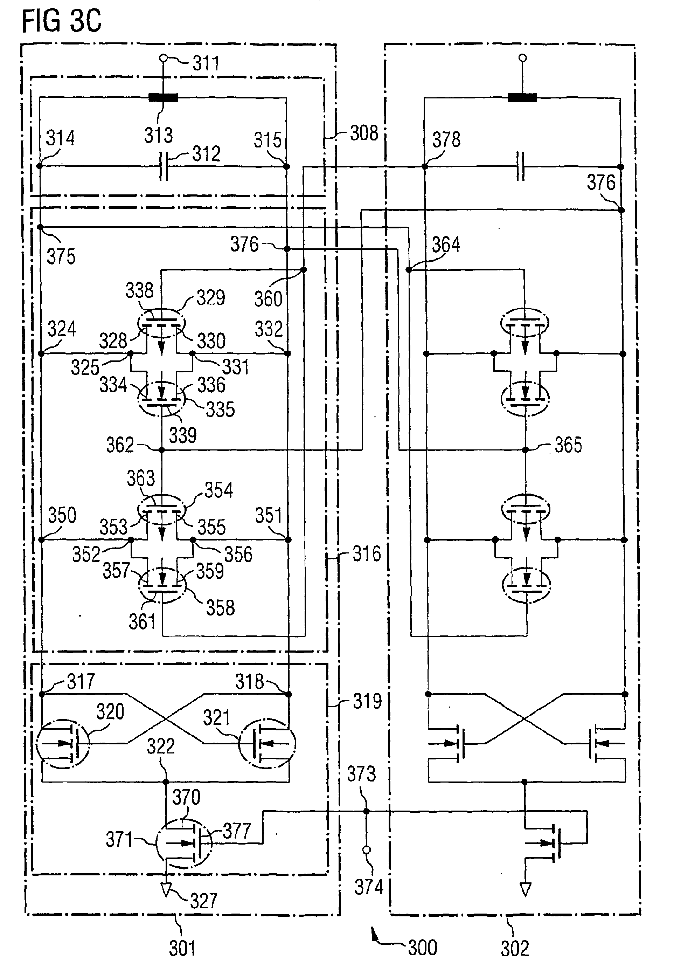

Bezugnehmend auf die **Fig. 3c** wird nachfolgend ein anderes Ausführungsbeispiel eines Injection-Locked-Oscillator-Schaltkreises beschrieben, welcher sich von dem in Fig. 3b gezeigten hauptsächlich dadurch unterscheidet, dass die Kopplung der beiden Oszillatorstufen anders durchgeführt ist, dass der erste Oszillatortransistor-Teilsschaltkreis weggelassen ist und im zweiten Oszillatortransistor-Teilsschaltkreis ein zusätzlicher Transistor angeordnet ist, welcher verwendet wird, um mittels einer an den Gateanschluss des Transistors angelegten Vorspannung die Bezugsspannungsquelle schalten zu können.

Die erste Oszillatorstufe 301 des ILO-Schaltkreises 300 der Fig. 3c weist ein LC-Glied 308, einen Koppeltransistor-Teilschaltkreis 316 und einen Oszillatortransistor-Teilschaltkreis 319 auf.

Das LC-Glied 308 weist eine Induktivität 313 und eine Kapazität 312 auf, welche parallel verschaltet sind. Zusätzlich ist die Induktivität 313 mit einer Versorgungsspannungsquelle gekoppelt 311 gekoppelt. Das LC-Glied 308 ist ferner mittels eines fünften Knoten 314 und eines sechsten Knotens 315 parallel mit dem Koppeltransistor-Teilschaltkreis 316 geschaltet.

Der Koppeltransistor-Teilschaltkreis 316 wird nachfolgend ausführlicher beschreiben werden. Ferner ist der Koppeltransistor-Teilschaltkreis 316 mittels eines siebten Knotens 317 und eines achten Knotens 318 an einen Oszillatortransistor-Teilschaltkreis 319 gekoppelt.

Der Oszillatortransistor-Teilschaltkreis 319 weist einen dritten Transistor 320 und einen vierten Transistor 321 auf, welche kreuzweise miteinander verschaltet sind. Ferner weist der Oszillatortransistor-Teilschaltkreis 319, einen neunten Knoten 322 auf, welcher zwischen den dritten und der vierten Transistor gekoppelt ist. Der neunte Knoten 322 ist mit einem ersten Source/Drain-Anschluss 370 eines neunten Transistor 371 gekoppelt. Der zweite Source/Drain-Anschluss 372 des neunten Transistor 371 ist mit einer Bezugsspannungsquelle 327 gekoppelt. Der Gateanschluss 377 des neunten Transistors ist mit einem dreiundzwanzigsten Knoten 373 gekoppelt, welcher mit einer Vorspannungsquelle 374 gekoppelt ist.

Im Weiteren wird der Koppeltransistor-Teilschaltkreis 316 näher beschrieben. Der Koppeltransistor-Teilschaltkreis 316 weist einen elften Knoten 324 auf, welcher mit einem vierundzwanzigsten Knoten 375 gekoppelt ist. Der vierundzwanzigste Knoten 375 ist mit dem fünften Knoten 314 gekoppelt ist. Ferner ist der elfte Knoten mit einem zwölften Knoten 325 und mit einem siebzehnten Knoten 350 gekoppelt. Der siebzehnte Knoten 350 ist mit dem siebten Knoten 317 gekoppelt.

Der zwölfte Knoten 325 ist mit einem ersten Source/Drain-Anschluss 328 eines fünften Transistors 329 gekoppelt. Der zweite Source/Drain-Anschluss 330 des fünften Transistors 329 ist mit einem vierzehnten Knoten 331 gekoppelt. Der vierzehnte Knoten 331 ist mit einem fünfzehnten Knoten gekoppelt 332, welcher an einen fünfundzwanzigsten Knoten 376 gekoppelt ist, welcher an den sechsten Knoten 315 gekoppelt ist. Ferner ist der fünfzehnte Knoten 332 mit einem achtzehnten Knoten 351 gekoppelt ist, welcher wiederum mit dem achten Knoten 318 gekoppelt ist.

Der zwölfte Knoten 325 ist ferner mit einem ersten Source/Drain-Anschluss 334 eines sechsten Transistors 335 gekoppelt. Der zweite Source/Drain-Anschluss 336 des sechsten Transistors 335 ist mit dem vierzehnten Knoten 331 gekoppelt.

Der fünfte Transistor 329 ist im Ausführungsbeispiel ein PMOS-Transistor mit Bulk-Anschluss, wohingegen der sechste Transistor 335 im Ausführungsbeispiel ein NMOS-Transistor mit einem Bulk-Anschluss ist. Es kann jedoch auch umgekehrt sein, zu beachten ist nur, dass die beiden Transistoren vorzugsweise entgegengesetzten Typs sind.

Der siebzehnte Knoten 350 ist mit einem neunzehnten Knoten 352 gekoppelt. Der neunzehnte Knoten 352 ist mit einem ersten Source/Drain-Anschluss 353 eines siebten Transistors 354 gekoppelt. Der zweite Source/Drain-Anschluss 355 des siebten Transistors 354 ist mit einem zwanzigsten Knoten 356 gekoppelt. Der zwanzigsten Knoten 356 ist mit dem achtzehnten Knoten 351 gekoppelt.

Der neunzehnte Knoten 352 ist ferner mit einem ersten Source/Drain-Anschluss 357 eines achten Transistors 358 gekoppelt. Der zweite Source/Drain-Anschluss 359 des achten Transistors 358 ist mit dem zwanzigsten Knoten 356 gekoppelt.

Der fünfte Transistor 329 und der siebte Transistor 354 sind im Ausführungsbeispiel PMOS-Transistoren mit Bulk-Anschluss, wohingegen der siebte Transistor 354 und der achte Transistor 358 im Ausführungsbeispiel NMOS-Transistoren mit einem Bulk-Anschluss sind. Es kann jedoch auch umgekehrt sein. Zu beachten ist nur, dass der fünfte Transistor 329 und der siebte Transistor 354 vorzugsweise gleichen Typs sind, wohingegen der sechste Transistor 335 und der achte Transistor 358 vorzugsweise gleichen Typs aber vom anderen Typ als der fünfte Transistor 329 und der siebte Transistor 354 sind.

Der Gateanschluss 338 des fünften Transistors 329 ist mit einem einundzwanzigsten Knoten 360 gekoppelt, welcher mit dem Gateanschluss 361 des achten Transistors 358 gekoppelt ist. Der Gateanschluss 339 des sechsten Transistors 335 ist mit einem zweiundzwanzigsten Knoten 362 gekoppelt, welcher mit dem Gateanschluss 363 des siebten Transistors 354 gekoppelt ist.

Im Ausführungsbeispiel der Fig. 3c bilden die bisher beschriebenen Elemente die erste Oszillatorstufe 301 des Injection-Locked-Oscillator-Schaltkreises 300. Die zweite Oszillatorstufe 302 des Injection-Locked-Oscillator-Schaltkreises 300 ist baugleich mit der ersten Oszillatorstüfe 301. Deshalb wird nachfolgend nur die Kopplung der beiden Oszillatorstufen näher beschrieben.

Der Kopplung der beiden Oszillatorstufen dienen der fünfte Knoten 378 der zweiten Oszillatorstufe 302, die einundzwanzigsten Knoten, die zweiundzwanzigsten Knoten, der vierundzwanzigsten Knoten 375 der ersten Oszillatorstufe 301 und die fünfundzwanzigsten Knoten.

Die Kopplung der beiden Oszillatorstufen ist wie folgt:
Der einundzwanzigsten Knoten 360 der ersten Oszillatorstufe 301 ist mit dem fünften Knoten 378 der zweiten Oszillatorstufe 302 gekoppelt.
Der zweiundzwanzigsten Knoten 362 der ersten Oszillatorstufe 301 ist mit dem fünfundzwanzigsten Knoten 376 der zweiten Oszillatorstufe 302 gekoppelt.
Der vierundzwanzigste Knoten 375 der ersten Oszillatorstufe 301 ist mit dem einundzwanzigsten Knoten 364 der zweiten Oszillatorstufe 302 gekoppelt.
Der fünfundzwanzigsten Knoten 376 der ersten Oszillatorstufe 301 ist mit dem zweiundzwanzigsten Knoten 365 der zweiten Oszillatorstufe 302 gekoppelt.

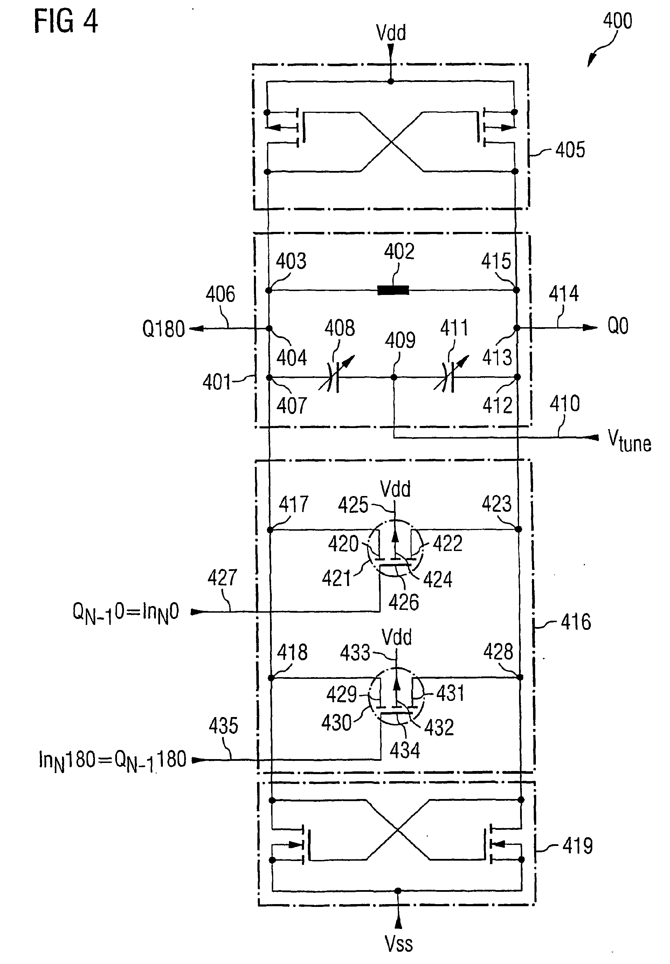

Nachfolgend wird anhand der **Fig. 4** eine Oszillatorstufe 400 erläutert, welche in einem Injection-Locked-Oscillator-Schaltkreis mit zwei Oszillatorstufen verwendet werden kann und welche größtenteils gleich der in Fig. 3a dargestellten ist. Jedoch ist in Fig. 4 die Kapazität als Varaktor ausgebildet, welcher mit einer Abstimmspannungsquelle gekoppelt ist, welche in Fig. 4 und den nachfolgenden Figuren auch als Vtune bezeichnet ist, die Bulk-Anschlüsse eines ersten und eines zweiten Transistors sind mit einer Versorgungsspannungsquelle, wobei Versorgungsspannungsquellen in der Fig. 4 und auch den nachfolgenden Figuren auch als Vdd bezeichnet sind, gekoppelt und die Bulk-Anschlüsse eines dritten und eines vierten Transistors sind mit einer Bezugsspannungsquelle, wobei Bezugsspannungsquellen in der Fig. 4 und auch den nachfolgenden Figuren auch als Vss bezeichnet sind, gekoppelt.

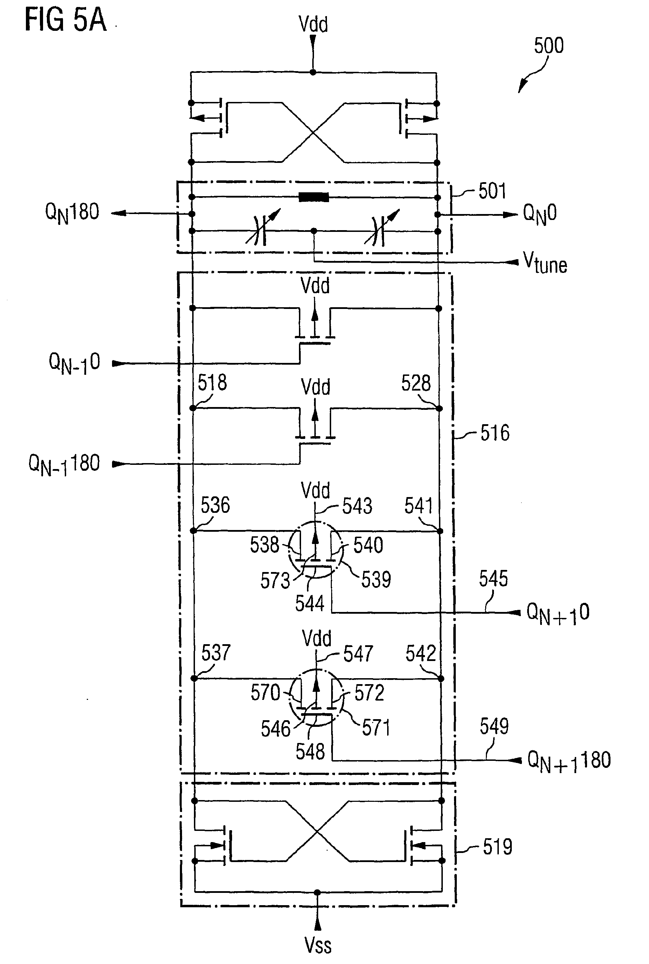

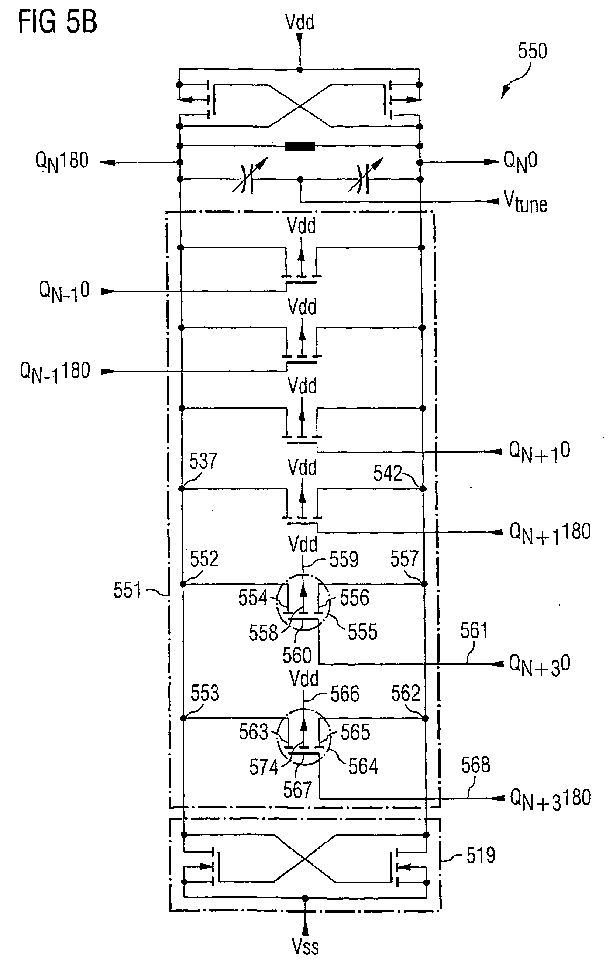

Da anhand der Fig. 4 auch die nachfolgenden Fig. 5a und 5b erläutert werden sollen, wird nochmals genauer auf das LC-Glied 401 und den Koppeltransistor-Teilschaltkreis 416 eingegangen.

Das LC-Glied 401 weist eine Induktivität 402 auf, deren einer Anschluss an einen ersten Knoten 403 gekoppelt ist. Der erste Knoten 403 ist mit einem zweiten Knoten 404 gekoppelt. Ferner ist der erste Knoten 403 an einem ersten Oszillatortransistor-Teilschaltkreis 405 gekoppelt, welcher wie im Ausführungsbeispiel der Fig. 3a ausgebildet ist. Der zweite Knoten 404 stellt einen ersten Ausgangsanschluss 406 der Oszillatorstufe dar. Ferner ist der zweite Knoten 404 mit einem dritten Knoten 407 gekoppelt, welcher mit einem ersten Anschluss eines ersten Varaktors 408 gekoppelt ist. Der zweite Anschluss des ersten Varaktors 408 ist mit einem vierten Knoten 409 gekoppelt, welcher mit einer Abstimmungsspannungsquelle 410 gekoppelt ist. Der vierte Knoten 409 ist ferner mit einem ersten Anschluss eines zweiten Varaktors 411 gekoppelt. Der zweite Anschluss des zweiten Varaktors 411 ist mit einem fünften Knoten 412 gekoppelt, welcher mit einem sechsten Knoten 413 gekoppelt ist. Die beiden Varaktoren können auch als ein einzelnen Varaktor ausgebildet sein. Der sechste Knoten 413 stellt einen zweiten Ausgangsanschluss 414 der Oszillatorstufe dar und ist ferner mit einem siebten Knoten 415 gekoppelt. Der siebte Knoten 415 ist mit dem zweiten Anschluss der Induktivität 402 gekoppelt. Ferner ist der siebte Knoten 413 an den ersten Oszillatortransistor-Teilschaltreis 405 gekoppelt.

Nachfolgend wird der Koppeltransistor-Teilschaltkreis 416 beschrieben. Der dritte Knoten 407 ist mit einem achten Knoten 417 gekoppelt, welcher mit einem neunten Knoten 418 gekoppelt ist. Der neunte Knoten 418 ist an einen zweiten Oszillatortransistor-Teilschaltkreis 419 gekoppelt.

Der achte Knoten 417 ist mit einem ersten Source/Drain-Anschluss 420 eines ersten Transistors 421 gekoppelt. Der zweite Source/Drain-Anschluss 422 des ersten Transistors 421 ist mit einem zehnten Knoten 423 gekoppelt. Ein Bulk-Anschluss 424 des ersten Transistors 421 ist mit einer Versorgungsspannungsquelle 425 gekoppelt. Versorgungsspannungsquellen sind in dieser Figur und den nachfolgenden Figuren zusätzlich mit Vdd bezeichnet. Der Gateanschluss 426 des ersten Transistors 421 stellt einen ersten Eingangsanschluss 427 der Oszillatorstufe dar. Eingangsanschlüsse sind in dieser Figur zusätzlich mit In0 bzw. In180 bezeichnet, wobei sich die 0 bzw. 180 auf die relative Phasenlage bezieht. In den nachfolgenden Figuren, werden sie auch mit Qₙ₋₁, Qₙ₊₁ oder Qₙ₊₃ bezeichnet, wobei sich der Index n immer auf eine n-te Oszillatorstufe des ILO-Schaltkreises bezieht. Der zehnte Knoten 423 ist mit dem fünften Knoten 412 des LC-Gliedes 401 gekoppelt. Ferner ist der zehnte Knoten 423 mit einem elften Knoten 428 gekoppelt. Der elfte Knoten 428 ist an den zweiten Oszillatortransistor-Teilschaltkreis 419 gekoppelt.

Der neunte Knoten 418 ist mit einem ersten Source/Drain-Anschluss 429 eines zweiten Transistors 430 gekoppelt. Der zweite Source/Drain-Anschluss 431 des zweiten Transistors 430 ist mit dem elften Knoten 428 gekoppelt. Ein Bulk-Anschluss 432 des zweiten Transistors 430 ist mit einer Versorgungsspannungsquelle 433 gekoppelt. Der Gateanschluss 434 des zweiten Transistors 430 stellt einen zweiten Eingangsanschluss 435 der Oszillatorstufe dar.

Die Spannungen, welche die Versorgungsspannungsquellen 425 und 433 zur Verfügung stellen sind identisch. Die Signale, welche an dem ersten Ausgangsanschluss 406 und am zweiten Ausgangsanschluss 414 anliegen, sind in ihrer Phasenlage um 180° zueinander verschoben. Signale, welche eine solche Phasenlage aufweisen, werden auch als differenziell zueinander bezeichnet.

Bei einer Kopplung von zwei der soeben beschriebenen Oszillatorstufen zu einem ILO-Schaltkreis wird der erste Ausgangsanschluss 406 der ersten Oszillatorstufe mit dem zweiten Eingangsanschluss 435 der zweiten Oszillatorstufe gekoppelt und der zweite Ausgangsanschluss 414 der ersten Oszillatorstufe mit dem ersten Eingangsanschluss 427 der zweiten Oszillatorstufe gekoppelt. Ferner ist der erste Ausgangsanschluss 406 der zweiten Oszillatorstufe mit dem ersten Eingangsanschluss 427 der ersten Oszillatorstufe gekoppelt und der zweite Ausgangsanschluss 414 der zweiten Oszillatorstufe mit dem ersten Eingangsanschluss 435 der zweiten Oszillatorstufe.

Die oben erläuterte Kopplung der Bulk-Anschlüsse ist hierbei nur beispielhaft zu sehen. Erfindungsgemäß können die Bulk-Anschlüsse der Transistoren außer mit einer Versorgungsspannung z.B. auch mit einem Mittenpotential, einer Bezugsspannungsquelle, mit Masse, floated und/oder mit dem Source-Anschluss gekoppelt sein.

Nachfolgend wird mit Bezug auf die Fig. 5a und 5b eine Oszillatorstufe erläutert, welche für einen ILO-Schaltkreis mit vier Oszillatorstufen bzw. für einen ILO-Schaltkreis mit sechs Oszillatorstufen geeignet ist.

Die in **Fig. 5a** dargestellt Oszillatorstufe 500 unterscheidet sich von der in Fig. 4 dargestellten Oszillatorstufe 400 nur durch die Anzahl der in dem Koppeltransistor-Teilschaltkreis vorhandenen Transistoren. Erfindungsgemäß weist eine Oszillatorstufe, welche in einen Oszillatorring mit vier Oszillatorstufen verwendet werden soll, vier Koppeltransistoren und damit auch vier Eingangsanschlüsse auf. Die zwei zusätzlichen Transistoren, sind zwischen einem neunten Knoten 518 und einem zweiten Oszillatortransistor-Teilschaltkreis 519 und einem elften Knoten 528 und dem zweiten Oszillatortransistor-Teilschaltkreis 519 eingekoppelt.

Im folgenden wird zur Erläuterung der in Fig. 5a dargestellte Koppeltransistor-Teilschaltkreis 516 der Oszillatorstufe 500 genauer beschrieben. Der neunte Knoten 518 ist mit einem zwölften Knoten 536 gekoppelt, welcher mit einem dreizehnten Knoten 537 gekoppelt ist. Der dreizehnte Knoten 537 ist an den zweiten Oszillatortransistor-Teilschaltkreis 519 gekoppelt.

Der zwölfte Knoten 536 ist mit einem ersten Source/Drain-Anschluss 538 eines dritten Transistors 539 gekoppelt. Der zweite Source/Drain-Anschluss 540 des dritten Transistors 539 ist mit einem vierzehnten Knoten 541 gekoppelt. Ein Bulk-Anschluss 573 des dritten Transistors 539 ist mit einer Versorgungsspannungsquelle 543 gekoppelt. Der Gateanschluss 544 des dritten Transistors 539 stellt einen dritten Eingangsanschluss 545 der Oszillatorstufe dar. Der vierzehnte Knoten 541 ist mit einem elften Knoten 528 gekoppelt. Ferner ist der vierzehnte Knoten 541 mit einem fünfzehnten Knoten 542 gekoppelt. Der fünfzehnte Knoten 542 ist an den zweiten Oszillatortransistor-Teilschaltkreis 519 gekoppelt.

Der dreizehnte Knoten 537 ist mit einem ersten Source/Drain-Anschluss 570 eines vierten Transistors 571 gekoppelt. Der zweite Source/Drain-Anschluss 572 des vierten Transistors 571 ist mit dem fünfzehnten Knoten 542 gekoppelt. Ein Bulk-Anschluss 546 des vierten Transistors 571 ist mit einer Versorgungsspannungsquelle 547 gekoppelt. Der Gateanschluss 548 des vierten Transistors 571 stellt einen vierten Eingangsanschluss 549 der Oszillatorstufe dar.

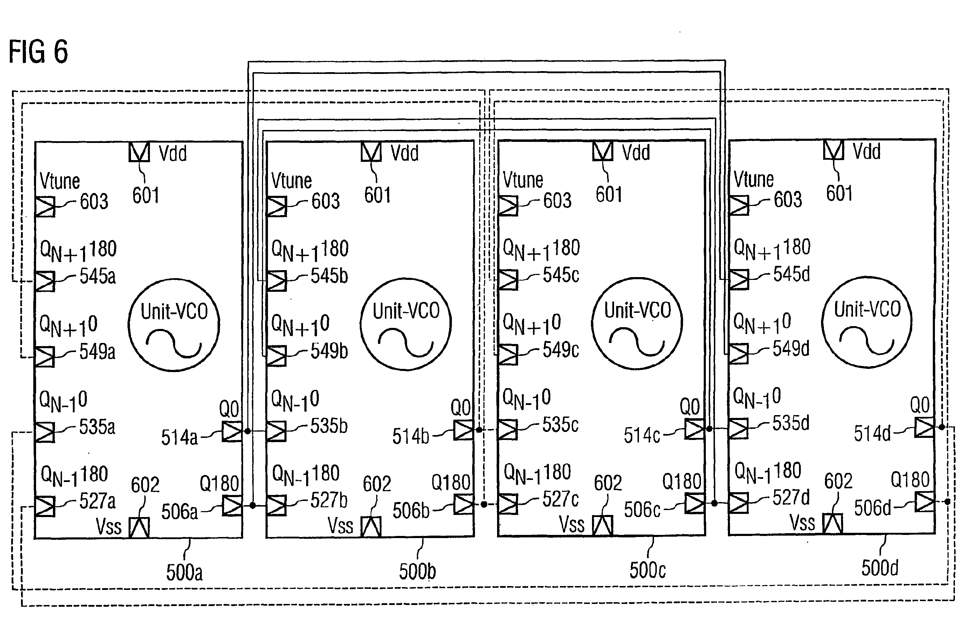

Die genaue Kopplung der einzelnen Oszillatorstufen wird nachfolgend mit Bezug auf die Fig. 6 genauer eingegangen.

Die in **Fig. 5b** dargestellte Oszillatorstufe 550 unterscheidet sich von der in Fig. 5a dargestellten Oszillatorstufe 500 nur durch die Anzahl der in dem Koppeltransistor-Teilschaltkreis vorhandenen Transistoren. Erfindungsgemäß weist eine Oszillatorstufe, welche in einem ILO-Schaltkreis mit sechs Oszillatorstufen verwendet werden soll, sechs Koppeltransistoren und damit auch sechs Eingangsanschlüsse auf. Die zwei zusätzlichen Transistoren, sind zwischen den dreizehnten Knoten 537 und dem zweiten Oszillatortransistor-Teilschaltkreis 519 und dem fünfzehnten Knoten 542 und dem zweiten Oszillatortransistor-Teilschaltkreis 519 eingekoppelt.

Im folgenden wird zur Erläuterung der in Fig. 5b dargestellte Koppeltransistor-Teilschaltkreis 551 der Oszillatorstufe 550 genauer beschrieben. Der dreizehnte Knoten 537 ist mit einem sechzehnten Knoten 552 gekoppelt, welcher mit einen siebzehnten Knoten 553 gekoppelt ist. Der siebzehnte Knoten 553 ist an den zweiten Oszillatortransistor-Teilschaltkreis 519 gekoppelt.

Der sechzehnte Knoten 552 ist mit einem ersten Source/Drain-Anschluss 554 eines fünften Transistors 555 gekoppelt. Der zweite Source/Drain-Anschluss 556 des fünften Transistors 555 ist mit einem achtzehnten Knoten 557 gekoppelt. Ein Bulk-Anschluss 558 des fünften Transistors 555 ist mit einer Versorgungsspannungsquelle 559 gekoppelt. Der Gateanschluss 560 des fünften Transistors 555 stellt einen fünften Eingangsanschluss 561 der Oszillatorstufe dar. Der achtzehnte Knoten 557 ist mit dem fünfzehnten Knoten 542 gekoppelt. Ferner ist der achtzehnte Knoten 557 mit einem neunzehnten Knoten 562 gekoppelt. Der neunzehnte Knoten 562 ist an den zweiten Oszillatortransistor-Teilschaltkreis 519 gekoppelt.

Der siebzehnte Knoten 553 ist mit einem ersten Source/Drain-Anschluss 563 eines sechsten Transistors 564 gekoppelt. Der zweite Source/Drain-Anschluss 565 des sechsten Transistors 564 ist mit dem neunzehnten Knoten 562 gekoppelt. Ein Bulk-Anschluss 574 des sechsten Transistors 564 ist mit einer Versorgungsspannungsquelle 566 gekoppelt. Der Gateanschluss 567 des sechsten Transistors 564 stellt einen sechsten Eingangsanschluss 568 der Oszillatorstufe 550 dar.

Nachfolgend wird unter Bezug auf die Fig. 6 die genaue Kopplung der in den Fig. 5a und 5b gezeigten einzelnen Oszillatorstufen erläutert.

In **Fig. 6** sind schematisch vier Oszillatorstufen 500a, 500b, 500c und 500d in der gleichen schematischen Darstellung, wie in der Fig. 11, dargestellt. Die Oszillatorstufen entsprechen dabei Oszillatorstufen wie sie in Fig. 5a dargestellt sind. Die vier Oszillatorstufen sind, miteinander verkoppelt.

Nachfolgend wird die schematische Darstellung von gekoppelten Oszillatorstufen im Detail beschrieben. Ein erster Ausgangsanschluss 506a einer ersten Oszillatorstufe 500a, welcher beispielsweise ein Signal mit einer Phasenlage von 180° bereitstellt, wird mit einem ersten Eingangsanschluss 527b einer zweiten Oszillatorstufe 500b gekoppelt, welcher Eingangsanschluss eine Phasenlage von 180° aufweist. Ein zweiter Ausgangsanschluss 514a der ersten Oszillatorstufe 500a, welcher im Beispiel ein Signal mit einer Phasenlage von 0° bereitstellt, wird mit einem zweiten Eingangsanschluss 535b der zweiten Oszillatorstufe 500b gekoppelt, welcher Eingangsanschluss eine Phasenlage von 0° aufweist. Ferner wird der erste Ausgangsanschluss 506a der ersten Oszillatorstufe 500a mit einem dritten Eingangsanschluss 545d einer vierten Oszillatorstufe 500d gekoppelt. Der zweite Ausgangsanschluss 514a der ersten Oszillatorstufe 500a wird ferner mit einem vierten Eingangsanschluss 549d der vierten Oszillatorstufe 500d gekoppelt.

Ein erster Ausgangsanschluss 506b der zweiten Oszillatorstufe 500b, welcher beispielsweise ein Signal mit einer Phasenlage von 180° bereitstellt, wird mit einem ersten Eingangsanschluss 527c einer dritten Oszillatorstufe 500c gekoppelt, welcher Eingangsanschluss eine Phasenlage von 180° aufweist. Ein zweiter Ausgangsanschluss 514b der zweiten Oszillatorstufe 500b, welcher im Beispiel ein Signal mit einer Phasenlage von 0° bereitstellt, wird mit einem zweiten Eingangsanschluss 535c der dritten Oszillatorstufe 500c gekoppelt, welcher Eingangsanschluss eine Phasenlage von 0° aufweist. Ferner wird der erste Ausgangsanschluss 506b der zweiten Oszillatorstufe 500b mit einem dritten Eingangsanschluss 545a der ersten Oszillatorstufe 500a gekoppelt. Der zweite Ausgangsanschluss 514b der zweiten Oszillatorstufe 500b wird ferner mit einem vierten Eingangsanschluss 549a der ersten Oszillatorstufe 500a gekoppelt.

Ein erster Ausgangsanschluss 506c der dritten Oszillatorstufe 500c, welcher beispielsweise ein Signal mit einer Phasenlage von 180° bereitstellt, wird mit einem ersten Eingangsanschluss 527d einer vierten Oszillatorstufe 500d gekoppelt, welcher Eingangsanschluss eine Phasenlage von 180° aufweist. Ein zweiter Ausgangsanschluss 514c der dritten Oszillatorstufe 500c, welcher im Beispiel ein Signal mit einer Phasenlage von 0° bereitstellt, wird mit einem zweiten Eingangsanschluss 535d der vierten Oszillatorstufe 500d gekoppelt, welcher Eingangsanschluss eine Phasenlage von 0° aufweist. Ferner wird der erste Ausgangsanschluss 506c der dritten Oszillatorstufe 500c mit einem dritten Eingangsanschluss 545b der zweiten Oszillatorstufe 500b gekoppelt. Der zweite Ausgangsanschluss 514c der dritten Oszillatorstufe 500c wird ferner mit einem vierten Eingangsanschluss 549b der zweiten Oszillatorstufe 500b gekoppelt.

Ein erster Ausgangsanschluss 506d der vierten Oszillatorstufe 500d, welcher beispielsweise ein Signal mit einer Phasenlage von 180° bereitstellt, wird mit einem ersten Eingangsanschluss 527a einer ersten Oszillatorstufe 500a gekoppelt, welcher Eingangsanschluss eine Phasenlage von 180° aufweist. Ein zweiter Ausgangsanschluss 514d der vierten Oszillatorstufe 500d, welcher im Beispiel ein Signal mit einer Phasenlage von 0° bereitstellt, wird mit einem zweiten Eingangsanschluss 535a der ersten Oszillatorstufe 500a gekoppelt, welcher Eingangsanschluss eine Phasenlage von 0° aufweist. Ferner wird der erste Ausgangsanschluss 506d der vierten Oszillatorstufe 500d mit einem dritten Eingangsanschluss 545c der dritten Oszillatorstufe 500c gekoppelt. Der zweite Ausgangsanschluss 514d der vierten Oszillatorstufe 500d wird ferner mit einem vierten Eingangsanschluss 549c der dritten Oszillatorstufe 500c gekoppelt.

Damit ist die erfindungsgemäße Kopplung vierer erfindungsgemäßen Öszillatorstufen zu einem ILO-Schaltkreis oder auch Oszillatorring vollständig beschrieben. Zusätzlich werden die einzelnen Oszillatorstufen noch mittels eines Versorgungsspannungsanschlusses 601 an eine Versorgungsspannungsquelle, eines Bezugsspannungsanschlusses 602 an eine Bezugsspannungsquelle und eines Abstimmspannungsanschlusses 603 an eine Abstimmspannungsquelle angekoppelt.

Bei der erfindungsgemäßen Verkopplung von Oszillatorstufen zu einem ILO-Schaltkreis können beliebig viele Oszillatorstufen miteinander verkoppelt werden. Vorzugsweise wird jedoch eine gerade Anzahl von Oszillatorstufen miteinander zu einem ILO-Schaltkreis gekoppelt. In dem Falle weisen die Oszillatorstufen genau soviele Eingangsanschlüsse auf, wie Oszillatorstufen in dem ILO-Schaltkreis miteinander verkoppelt sind. D.h. wenn sechs Oszillatorstufen verkoppelt werden, weißt jede der sechs Oszillatorstufen sechs Eingangsanschlüsse auf. Die Verkopplung der sechs einzelnen identisch aufgebauten Oszillatorstufen erfolgt dann in der Weise, dass die Eingangsanschlüsse der ersten Oszillatorstufe mit den Ausgangsanschlüssen der zweiten, der vierten und der sechsten Oszillatorstufe gekoppelt wird, d.h. mit den Ausgangsanschlüssen jeder zweiten Oszillatorstufe. Allgemein kann gesagt werden, dass bei einem Oszillatorring mit k-Oszillatorstufen die Eingangsanschlüsse der n-ten Oszillatorstufe mit den Ausgangsanschlüssen von allen mod(*n*+*x;k*) Oszillatorstufen gekoppelt ist, wobei x alle ungeraden Zahlen von 1 bis k durchläuft, oder mathematisch ausgedrückt *x*={*x*|mod(*x*+1;2)=0}, wobei "mod" die Modulofunktion darstellt.

Vorzugsweise beschränkt man sich auf eine gerade Anzahl von Oszillatorstufen, was sich aus der Phasendifferenz zwischen zwei aufeinanderfolgende Stufen ergibt. Die Phasendifferenz ist festgelegt auf ±90'. Hierfür lässt sich eine anschauliche Erklärung geben. Die Erklärung wird wegen der Einfachheit für einen ILO-Schaltkreis aus zwei Oszillatorstufen gegeben, gilt jedoch allgemein für eine gerade Anzahl von Oszillatorstufen.

Die Gate-Spannungen der Koppeltransistoren der zweiten Oszillatorstufe, d.h. der Eingangsanschlüsse der zweiten Oszillatorstufe, sind gegeben durch die zueinander um 180° phasenverschobenen Ausgangssignale, welche an den Ausgangsanschlüssen der ersten Oszillatorstufe anliegen. Ist eines der Ausgangssignale der ersten Oszillatorstufe, welches dann gleich der Gate-Spannung des entsprechenden Koppeltransistors ist, auf einen minimalen Wert, so ist die Gate-Spannung des Koppeltransistors, welcher mit dem um 180° phasenverschobenen zweiten Ausgangsignals der ersten Oszillatorstufe gekoppelt ist, maximal. Somit wird einer der beiden Koppeltransistoren der zweiten Stufe stark leitend und die beiden Ausgangsknoten, d.h. Ausgangsanschlüsse, der zweiten Oszillatorstufe werden auf dieselbe Spannung gebracht, d.h. es ergibt sich ein Nulldurchgang der Ausgangssignale der zweiten Oszillatorstufe. Somit fallen die Nulldurchgänge der Ausgangssignale der zweiten Oszillatorstufe mit den Maximal/Minimalwerten der ersten Oszillatorstufe zusammen. Für die erste Stufe gilt jedoch, dass die Minimal/Maximalwerte und die Nulldurchgänge in den Ausgangssignalen eine viertel Periode, d.h. 90°, phasenverschoben sind. Somit sind die Nulldurchgänge der ersten und zweite Oszillatorstufe, oder allgemein ausgedrückt zweier aufeinanderfolgender Oszillatorstufen, um ±90 verschoben.

Aus dem eben gesagten folgt auch direkt, dass nur eine gerade Anzahl von Oszillatorstufen möglich ist, da sonst die Forderung nach einer Phasendrehung nicht zu erfüllen ist, welche ein Vielfaches von 2n ist. Dies ist jedoch eine Bedingung die für jeden Oszillatorring zu erfüllen ist.

Mittels der unter Bezug auf Fig. 6 beschriebenen Kopplung wird also eine Synchronisierung der Nulldurchgänge einer Oszillatorstufe mit den Minima/Maxima der vorangehenden bzw. nachfolgenden Stufe bewirkt. Diese Synchronisation sorgt dafür, dass zeitliche Variationen in den Nulldurchgängen reduziert werden, was gleichbedeutend mit geringeren Phasenrauschen ist.

Bei der Verwendung von mehr als zwei Oszillatorstufen innerhalb eines ILO-Schaltkreises kann die Synchronisierung verstärkt werden und damit das Phasenrauschen zusätzlich reduziert werden. So wird bei einem ILO-Schaltkreis aus vier Oszillatorstufen jede Oszillatorstufe sowohl mit der nachfolgenden als auch mit der vorangehenden Oszillatorstufe synchronisiert.

Für die Koppeltransistoren in der betrachteten Realisierung wurden vorzugsweise PMOS-Transistoren verwendet, weil PMOS-Transistoren eine geringere so genannte "Flickernoise" aufweisen als NMOS-Transistoren. Prinzipiell ist es auch möglich die Kopplung mit nur einen Transistor pro rückkoppelnder Stufe durchzuführen, wodurch der ILO-Schaltkreis vereinfacht wird. Auch ist möglich ein Schaltelement durch ein Transferelement zu ersetzen, bzw. nur NMOS-Transistoren zu verwenden.

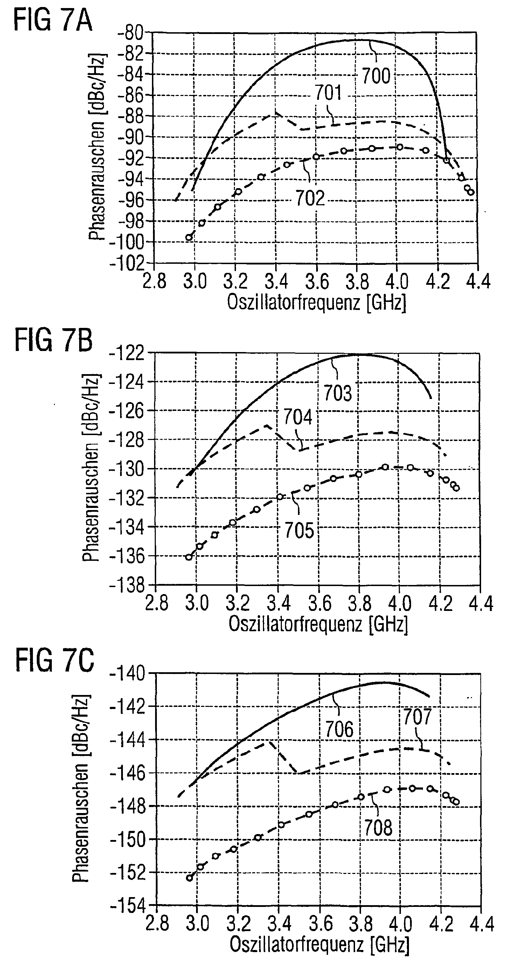

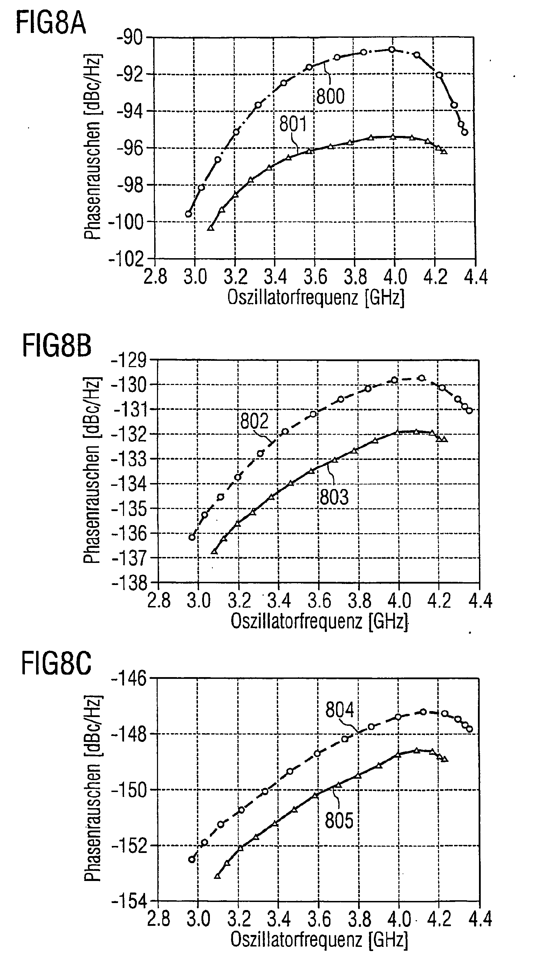

Der Vorteil gegenüber den Lösungen nach Stand der Technik, nämlich eine Verringerung des Phasenrauschens im Vergleich zu einstufigen Oszillatoren der gleichen Grundzelle, jedoch ohne erfindungsgemäße Koppeltransistoren, wird nachfolgend anhand der Fig. 7 und 8, welche Ergebnisse von Simulationen zeigen, ersichtlich. Ab einem Verwenden von vier Oszillatorstufen sind deutliche Vorteile im Phasenrauschen, d.h. geringeres Phasenrauschen, gegenüber der mit Bezug auf Fig. 12 und 14 beschriebenen parallelen Kopplung zu erzielen. Gemäß dem Stand der Technik ist die parallele Kopplung die Kopplung, welche das geringste Phasenrauschen verursacht. Die Simulation und auch das Design zu den verschiedenen VCO-Konzepten wurde durchgeführt unter dem Gesichtspunkt, dass GSM-Frequenz-Spezifikationen erfüllt werden und innerhalb der Frequenzgrenzen von GSM-Anwendungen möglichst niedriges Phasenrauschen erreicht wird. Dabei interessieren alle Frequenzbänder von 850 MHz bis 1,90 GHz. Es ist ein dem VCO folgender Frequenzteiler (:2 bzw. :4) geplant, d.h. es wird ein Frequenztuning von 3 GHz bis 4,3 GHz benötigt.

In **Fig. 7** werden die Ergebnisse von Simulationen für eine Grundzelle, d.h. eine einzelne Oszillatorstufe, für einen ILO-Schaltkreis mit einer erfindungsgemäße Kopplung von zwei erfindungsgemäßen Oszillatorstufen und für einen ILO-Schaltkreis mit einer erfindungsgemäße Kopplung von vier erfindungsgemäßen Oszillatorstufen für drei unterschiedliche Offset-Frequenzen dargestellt.

**Fig. 7a** zeigt das Phasenrauschen in dBc/Hz, wobei dBc "dB with respect to carrier power" bedeutet, in Abhängigkeit zu der Oszillatorfrequenz für eine Offset-Frequenz von 100 kHz. In Fig. 7a stellt eine erste Kurve 700 den Verlauf des Phasenrauschens für eine Grundstufe, d.h. eine einzelne Oszillatorstufe dar. Eine zweite Kurve 701 stellt den Verlauf des Phasenrauschens für einen ILO-Schaltkreis mit zwei Oszillatorstufen dar, wohingegen eine dritte Kurve 702 den Verlauf für einen ILO-Schaltkreis mit vier Oszillatorstufen darstellt.

Deutlich zu sehen ist, dass mit zunehmender Anzahl von Oszillatorstufen je ILO-Schaltkreis das Phasenrauschen abnimmt. Im, in der Fig. 7a, mittleren Frequenzbereich von etwa 3,7 GHz nimmt das Phasenrauschen um etwa 10 dBc/Hz ab.

**Fig. 7b** zeigt das Phasenrauschen in dBc/Hz in Abhängigkeit zu der Oszillatorfrequenz für eine Offset-Frequenz von 3 MHz. In Fig. 7b stellt eine erste Kurve 703 den Verlauf des Phasenrauschens für eine Grundstufe, d.h. eine einzelne Oszillatorstufe dar. Eine zweite Kurve 704 stellt den Verlauf des Phasenrauschens für einen ILO-Schaltkreis mit zwei Oszillatorstufen dar, wohingegen eine dritte Kurve 705 den Verlauf für einen ILO-Schaltkreis mit vier Oszillatorstufen darstellt.

Deutlich zu sehen ist auch hier, dass mit zunehmender Anzahl von Oszillatorstufen je ILO-Schaltkreis das Phasenrauschen abnimmt. Bei einer Frequenz von etwa 3,9 GHz nimmt das Phasenrauschen um etwa 9 dBc/Hz ab. Zusätzlich ist anzumerken, dass das Phasenrauschen bei einer Offset-Frequenz von 3 MHz geringer ausfällt als bei einer Offset-Frequenz von 100 kHz.

**Fig. 7c** zeigt das Phasenrauschen in dBc/Hz in Abhängigkeit zu der Oszillatorfrequenz für eine Offset-Frequenz von 20 MHz. In Fig. 7c stellt eine erste Kurve 706 den Verlauf des Phasenrauschens für eine Grundstufe, d.h. eine einzelne Oszillatorstufe dar. Eine zweite Kurve 707 stellt den Verlauf des Phasenrauschens für einen ILO-Schaltkreis mit zwei Oszillatorstufen dar, wohingegen eine dritte Kurve 708 den Verlauf für einen ILO-Schaltkreis mit vier Oszillatorstufen darstellt.

Deutlich zu sehen ist auch hier, dass mit zunehmender Anzahl von Oszillatorstufen je ILO-Schaltkreis das Phasenrauschen abnimmt. Im Frequenzbereich von etwa 4,0 GHz nimmt das Phasenrauschen um etwa 8 dBc/Hz ab. Zusätzlich ist anzumerken, dass das Phasenrauschen bei einer Offset-Frequenz von 20 MHz nochmals geringer ausfällt als bei einer Offset-Frequenz von 3 MHz.

In **Fig. 8** werden die Ergebnisse von Simulationen für einen Oszillatorring gemäß dem Stand der Technik aus vier parallel gekoppelten Oszillatorstufen mit den Ergebnissen von Simulationen für einen erfindungsgemäßen ILO-Schaltkreis aus vier Oszillatorstufen für drei unterschiedliche Offset-Frequenzen verglichen.

**Fig. 8a** zeigt das Phasenrauschen in dBc/Hz in Abhängigkeit zu der Oszillatorfrequenz für eine Offset-Frequenz von 100kHz. In Fig. 8a stellt eine erste Kurve 800 den Verlauf des Phasenrauschens für einen Oszillatorring gemäß dem Stand der Technik mit vier parallel gekoppelten Oszillatorstufen dar, wohingegen eine zweite Kurve 801 den Verlauf für einen erfindungsgemäßen ILO-Schaltkreis mit vier Oszillatorstufen darstellt.

Deutlich zu sehen ist, dass das Phasenrauschen eines erfindungsgemäßen ILO-Schaltkreises deutlich niedriger als das Phasenrauschen eines Oszillatorringes gemäß dem Stand der Technik ist. Im dargestellten Frequenzbereich beträgt die Verbesserung durch den erfindungsgemäßen ILO-Schaltkreis etwa 3 bis 5 dBc/Hz.

**Fig. 8b** zeigt das Phasenrauschen in dBc/Hz in Abhängigkeit zu der Oszillatorfrequenz für eine Offset-Frequenz von 3 MHz. In Fig. 8b stellt eine erste Kurve 802 den Verlauf des Phasenrauschens für einen Oszillatorring gemäß dem Stand der Technik mit vier parallel gekoppelten Oszillatorstufen dar, wohingegen eine zweite Kurve 803 den Verlauf für einen erfindungsgemäßen ILO-Schaltkreis mit vier Oszillatorstufen darstellt.

Deutlich zu sehen ist, dass das Phasenrauschen eines erfindungsgemäßen ILO-Schaltkreises deutlich niedriger als das Phasenrauschen eines Oszillatorringes gemäß dem Stand der Technik ist. Im dargestellten Frequenzbereich beträgt die Verbesserung durch den erfindungsgemäßen ILO-Schaltkreis etwa 2 bis 3 dBc/Hz.

**Fig. 8c** zeigt das Phasenrauschen in dBc/Hz in Abhängigkeit zu der Oszillatorfrequenz für eine Offset-Frequenz von 20 MHz. In Fig. 8c stellt eine erste Kurve 804 den Verlauf des Phasenrauschens für einen Oszillatorring gemäß dem Stand der Technik mit vier parallel gekoppelten Oszillatorstufen dar, wohingegen eine zweite Kurve 805 den Verlauf für einen erfindungsgemäßen ILO-Schaltkreis mit vier Oszillatorstufen darstellt.

Deutlich zu sehen ist, dass das Phasenrauschen eines erfindungsgemäßen ILO-Schaltkreises deutlich niedriger als das Phasenrauschen eines Oszillatorringes gemäß dem Stand der Technik ist. Im dargestellten Frequenzbereich beträgt die Verbesserung durch den erfindungsgemäßen ILO-Schaltkreis etwa 2 dBc/Hz.

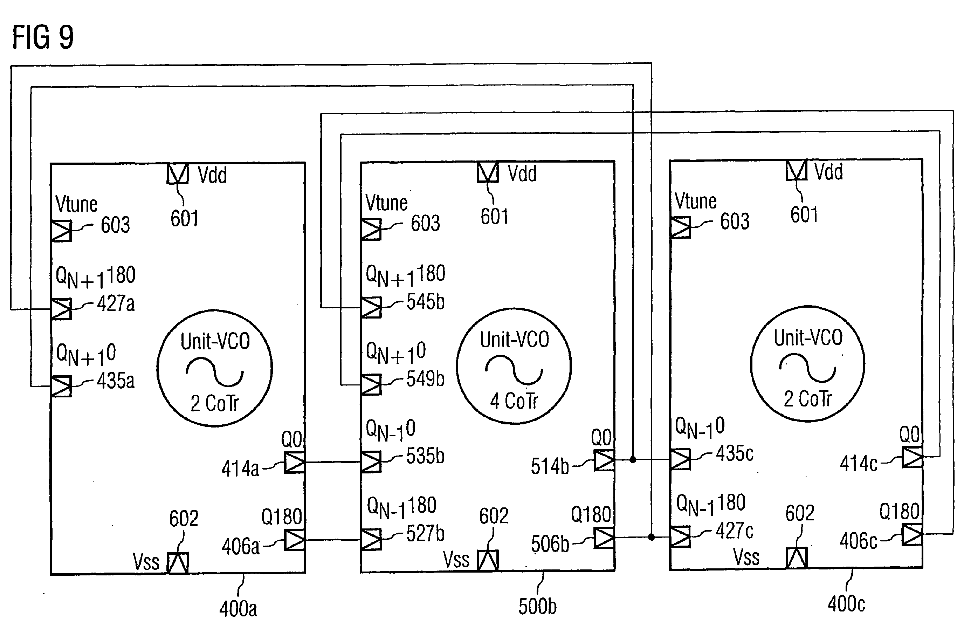

Neben der mit Bezugnahme auf Fig. 6 beschriebenen Kopplung von einer geraden Anzahl von Oszillatorstufen zu einem erfindungsgemäßen ILO-Schaltkreis wird nachfolgend mit Bezugnahme auf die Fig. 9 eine Kopplung einer ungeradzahligen Anzahl von Oszillatorstufen zu einem ILO-Schaltkreis beschrieben.

Bei einem ILO-Schaltkreis mit ungeradzahliger Anzahl von Oszillatorstufen unterscheiden sich die einzelnen Oszillatorstufen des ILO-Schaltkreises. Anhand der Fig. 9 wird die Kopplung eines ILO-Schaltkreises aus drei Oszillatorstufen 400a, 500b und 400c erläutert. Hierbei sind zwei Oszillatorstufen 400a und 400c mit zwei Koppeltransistoren, wie sie der in Fig. 4 dargestellten Oszillatorstufe entsprechen, und eine Oszillatorstufe 500b mit vier Koppeltransistoren, wie sie der in Fig. 5a dargestellten Oszillatorstufe entsprechen, ausgebildet.

In **Fig. 9** sind schematisch drei Oszillatorstufen 400a, 500b und 400c, wobei die Oszillatorstufen, in der gleichen schematischen Darstellung wie in den Fig. 6 und 11, dargestellt. Die drei Oszillatorstufen sind, miteinander verkoppelt.

Nachfolgend wird die schematische Darstellung von gekoppelten Oszillatorstufen im Detail beschrieben. Ein erster Ausgangsanschluss 406a einer ersten Oszillatorstufe 400a, welcher beispielsweise ein Signal mit einer Phasenlage von 180° bereitstellt, wird mit einem ersten Eingangsanschluss 527b einer zweiten Oszillatorstufe 500b gekoppelt, welcher Eingangsanschluss eine Phasenlage von 180° aufweist. Ein zweiter Ausgangsanschluss 414a der ersten Oszillatorstufe 400a, welcher im Beispiel ein Signal mit einer Phasenlage von 0° bereitstellt, wird mit einem zweiten Eingangsanschluss 535b der zweiten Oszillatorstufe 500b gekoppelt, welcher Eingangsanschluss eine Phasenlage von 0° aufweist.

Ein erster Ausgangsanschluss 506b der zweiten Oszillatorstufe 500b, welcher beispielsweise ein Signal mit einer Phasenlage von 180° bereitstellt, wird mit einem ersten Eingangsanschluss 427c einer dritten Oszillatorstufe 400c gekoppelt, welcher Eingangsanschluss eine Phasenlage von 180° aufweist. Ein zweiter Ausgangsanschluss 514b der zweiten Oszillatorstufe 500b, welcher im Beispiel ein Signal mit einer Phasenlage von 0° bereitstellt, wird mit einem zweiten Eingangsanschluss 435c der dritten Oszillatorstufe 400c gekoppelt, welcher Eingangsanschluss eine Phasenlage von 0° aufweist. Ferner wird der erste Ausgangsanschluss 506b der zweiten Oszillatorstufe 500b mit einem ersten Eingangsanschluss 427a der ersten Oszillatorstufe 400a gekoppelt. Der zweite Ausgangsanschluss 514b der zweiten Oszillatorstufe 500b wird ferner mit einem zweiten Eingangsanschluss 435a der ersten Oszillatorstufe 400a gekoppelt.

Ein erster Ausgangsanschluss 406c der dritten Oszillatorstufe 400c, welcher beispielsweise ein Signal mit einer Phasenlage von 180° bereitstellt, wird mit einem dritten Eingangsanschluss 545b der zweiten Oszillatorstufe 500b gekoppelt, welcher Eingangsanschluss eine Phasenlage von 180° aufweist. Ein zweiter Ausgangsanschluss 414c der dritten Oszillatorstufe 400c, welcher im Beispiel ein Signal mit einer Phasenlage von 0° bereitstellt, wird mit einem vierten Eingangsanschluss 549b der zweiten Oszillatorstufe 500b gekoppelt, welcher Eingangsanschluss eine Phasenlage von 0° aufweist.

Zusätzlich werden die einzelnen Oszillatorstufen noch mittels eines Versorgungsspannungsanschlusses 601 an eine Versorgungsspannungsquelle, eines Bezugsspannungsanschlusses 602 an eine Bezugsspannungsquelle und eines Abstimmspannungsanschlusses 603 an eine Abstimmspannungsquelle angekoppelt.

ILO-Schaltkreise mit ungeradzahliger Anzahl von Oszillatorstufen sind nicht auf drei Oszillatorstufen beschränkt. Es können beliebige Anzahlen von Oszillatorstufen verwendet werden. Beispielsweise besteht ein ILO-Schaltkreis aus fünf Oszillatorstufen aus drei Oszillatorstufen mit vier Koppeltransistoren und damit vier Eingangsanschlüssen und aus zwei Oszillatorstufen mit sechs Koppeltransistoren und damit sechs Eingangsanschlüssen, wobei die beiden "Arten" von Oszillatorstufen abwechselnd in dem ILO-Schaltkreis angeordnet sind.

Jede n-te Oszillatorstufe von k Oszillatorstufen ist dabei mit ihren Eingangsanschlüsse an die Ausgangsanschlüsse der mod(*n*+x;*k*) Oszillatorstufen gekoppelt, wobei x alle ungeraden Zahlen von 1 bis k durchläuft, oder mathematisch ausgedrückt *x*=(*x*|mod(*x*+1;2)=0), wobei "mod" die Modulofunktion darstellt. Hierbei ist bei ungerader Anzahl von Oszillatorstufen jedoch zu berücksichtigen, dass keine Oszillatorstufe eine Rückkopplung mit sich selber aufweist.

Zusammenfassend lässt sich sagen, dass mit der Erfindung ein ILO-Schaltkreis geschaffen wird, welcher eine Mehrzahl von Oszillatorstufen aufweist, welche mittels einer "Tank-Lock" Kopplung miteinander gekoppelt sind. Die erfindungsgemäße Kopplung führt zu einer verbesserten Synchronisation der einzelnen Oszillatorstufen und damit zu einem verringerten Phasenrauschen gegenüber einem Oszillatorring gemäß dem Stand der Technik. Erfindungsgemäß lässt sich jede beliebige LC-Oszillator-Topologie verwenden nicht nur die hier gezeigte Topologie mit PMOS- und NMOS-Transistoren, z.B. lassen sich auch SOI-Transistoren, d.h. Transistoren, welche auf einem SOI-Substrat ausgebildet werden, verwenden. Die oben erläuterte Kopplung der Bulk-Anschlüsse ist hierbei nur beispielhaft zu sehen. Erfindungsgemäß können die Bulk-Anschlüsse der Transistoren außer mit einer Versorgungsspannung z.B. auch mit einem Mittenpotential, einer Bezugsspannungsquelle, mit Masse, floatend und/oder mit dem Source-Anschluss gekoppelt sein.

In diesem Dokument sind folgende Veröffentlichungen zitiert:
[1] "Wireless CMOS Frequency Synthesizer Design"; J. Craninckx, M. Steyaert; Kluwer, Boston (1998); ISBN 0-7923-8138-0
[2] "The Design of Low Noise Oscillators"; A. Hajimiri, T.H. Lee; Kluwer, Boston (1999); ISBN 0-7923-8455-5
[3] "A 900-MHz CMOS LC Oscillator with Quadrature Outputs"; A. Rofourgaran et al.; IEEE Int. Solid-State Circuits Conf. (ISSCC); Dig. Tech. Papers (Feb. 1996); pp 392-393
[4] "Analysis and Design of a 1.8 GHz CMOS LC Quadrature VCO"; P. Andreani et al.; Journal of Solid State Circuits Vol. 37 No. 12 (Dec. 2002) pp. 1737-1747
[5] "A 1.8 GHz CMOS Quadrature Voltage Controlled Oscillator (VCO) Using the Constant Current LC Ring Oscillator Structure"; C.J. Wu, H.S. Kao; International Symposium on Circuits and Systems (1998) pp. 378-381
[6] "Low Power, Low-Phase-Noise differentially tuned Quadrature VCO Design in Standard CMOS"; Tiebout M., Journal of Soid State Circuits, Vol. 36, No. 7, (Jul. 2001) pp. 1018-1024
[7] "Single-Chip 900 MHz Spread-Spectrum Wireless Transceiver in 1-um CMOS-Part I: Architecture and Transmitter Design"; A. Rofourgaran et al.; Journal of Solid State Circuits, Vol. 33, No. 4, (Apr. 1998) pp. 515-534
[8] "A Low-Phase-Noise CMOS LC Oscillator with a Ring structure"; J.J. Kim and B. Kim; International Solid State Circuits Conference, Vol. XLIII (Feb. 2000) p. 430
[9] US 6 417 740 B1
[10] US 6 198 360 B1
[11] US 6 617 936 B2

### Bezugszeichenliste

- 100: ILO-Schaltkreis
- 101: erste Oszillatorstufe
- 102: zweite Oszillatorstufe
- 103: erste Kapazität
- 104: erster Knoten
- 105: erste Induktivität
- 106: zweiter Knoten
- 107: Ersatzwiderstand
- 108: Ersatzwiderstand
- 109: dritter Knoten
- 110: erster Source/Drain-Anschluss eines ersten Transistors
- 111: erster Transistor
- 112: zweiter Source/Drain-Anschluss des ersten Transistors
- 113: Gateanschluss des ersten Transistors
- 114: vierter Knoten
- 115: erster Source/Drain-Anschluss eines zweiten Transistors
- 116: zweiter Transistor
- 117: zweiter Source/Drain-Anschluss des zweiten Transistors
- 118: fünfter Knoten
- 119: zweite Induktivität
- 120: Ersatzwiderstand
- 121: sechster Knoten
- 122: zweite Kapazität
- 123: Ersatzwiderstand
- 124: Gateanschluss des zweiten Transistors
- 200: ILO-Schaltkreis
- 201: erste Oszillatorstufe
- 202: zweite Oszillatorstufe
- 203: erste Kapazität
- 204: erster Knoten
- 205: erste Induktivität
- 206: zweiter Knoten
- 207: Ersatzwiderstand
- 208: Ersatzwiderstand
- 209: dritter Knoten
- 210: vierter Knoten
- 211: erster Source/Drain-Anschluss eines ersten Transistors
- 212: erster Transistor
- 213: zweiter Source/Drain-Anschluss des ersten Transistors
- 214: fünfter Knoten
- 215: sechster Knoten
- 216: erstes aktives Element (negativer Widerstand)
- 217: siebter Knoten
- 218: erster Source/Drain-Anschluss eines zweiten Transistors
- 219: zweiter Transistor
- 220: zweiter Source/Drain-Anschluss des zweiten Transistors
- 222: achter Knoten
- 223: Gateanschluss des ersten Transistors
- 224: neunter Knoten
- 225: erster Source/Drain-Anschluss eines dritten Transistors
- 226: dritter Transistor ,
- 227: zweiter Source/Drain-Anschluss des dritten Transistors
- 228: zehnter Knoten
- 229: Gateanschluss des zweiten Transistors
- 230: elfter Knoten
- 231: erster Source/Drain-Anschluss eines vierten Transistors
- 232: vierter Transistor
- 233: zweiter Source/Drain-Anschluss des vierten Transistors
- 234: zwölfter Knoten
- 235: Gateanschluss des vierten Transistors
- 236: dreizehnter Knoten
- 237: zweites aktive Element
- 238: vierzehnter Knoten
- 239: fünfzehnter Knoten
- 240: zweite Induktivität
- 241: Ersatzwiderstand
- 242: sechzehnter Knoten
- 243: zweite Kapazität
- 244: Ersatzwiderstand
- 245: Gateanschluss des dritten Transistors
- 300: ILO-Schaltkreis
- 301: erste Oszillatorstufe
- 302: zweite Oszillatorstufe
- 303: erster Oszillatortransistor-Teilschaltkreis
- 304: erster Transistor
- 305: zweiter Transistor
- 306: erster Knoten
- 307: zweiter Knoten
- 308: LC-Glied
- 309: dritter Knoten
- 310: vierter Knoten
- 311: Versorgungsspannungsquelle
- 312: Kapazität
- 313: Induktivität
- 314: fünfter Knoten
- 315: sechster Knoten
- 316: Koppeltransistor-Teilschaltkreis
- 317: siebter Knoten
- 318: achter Knoten
- 319: zweiter Oszillatortransistor-Teilschaltkreis
- 320: dritter Transistor
- 321: vierter Transistor
- 322: neunter Knoten
- 323: zehnten Knoten
- 324: elfter Knoten
- 325: zwölfter Knoten
- 326: dreizehnter Knoten
- 327: Bezugsspannungsquelle
- 328: erster Source/Drain-Anschluss eines fünften Transistors
- 329: fünfter Transistor
- 330: zweiter Source/Drain-Anschluss des fünften Transistors
- 331: vierzehnter Knoten
- 332: fünfzehnter Knoten
- 333: sechzehnter Knoten
- 334: erster Source/Drain-Anschluss eines sechsten Transistors
- 335: sechster Transistor
- 336: zweiter Source/Drain-Anschluss des sechsten Transistors
- 337: Koppeltransistor-Teilschaltkreis
- 338: Gateanschluss des fünften Transistors
- 339: Gateanschluss des sechsten Transistors
- 340: vierter Knoten der zweiten Oszillatorstufe
- 341: zehnter Knoten der zweiten Oszillatorstufe
- 342: dreizehnter Knoten der zweiten Oszillatorstufe
- 343: sechzehnter Knoten der zweiten Oszillatorstufe
- 344: Gateanschluss des fünften Transistors der zweiten Oszillatorstufe
- 345: fünfter Transistor der zweiten Oszillatorstufe
- 346: Gateanschluss des sechsten Transistors der zweiten Oszillatorstufe
- 347: sechster Transistor der zweiten Oszillatorstufe
- 350: siebzehnter Knoten
- 351: achtzehnter Knoten
- 352: neunzehnter Knoten
- 353: erster Source/Drain-Anschluss eines siebten Transistors
- 354: siebter Transistor
- 355: zweiter Source/Drain-Anschluss des siebten Transistors
- 356: zwanzigster Knoten
- 357: erster Source/Drain-Anschluss eines achten Transistors
- 358': achter Transistor
- 359: zweiter Source/Drain-Anschluss des achten Transistors
- 360: einundzwanzigster Knoten
- 361: Gateanschluss des achten Transistors
- 362: zweiundzwanzigster Knoten
- 363: Gateanschluss des siebten Transistors
- 364: einundzwanzigster Knoten der zweiten Oszillatorstufe
- 365: zweiundzwanzigster Knoten der zweiten Oszillatorstufe
- 370: erster Source/Drain-Anschluss eines neunten Transistors
- 371: neunter Transistor
- 372: zweiter Source/Drain-Anschluss des neunten Transistors
- 373: dreiundzwanzigste Knoten
- 374: Vorspannungsquelle
- 375: vierundzwanzigste Knoten
- 376: vierundzwanzigste Knoten der zweiten Oszillatorstufe
- 377: Gateanschluss des neunten Transistors
- 378: Fünfter Knoten der zweiten Oszillatorstufe
- 400: Oszillatorstufe
- 401: LC-Glied
- 402: Induktivität
- 403: erster Knoten
- 404: zweiter Knoten
- 405: erster Oszillatortransistor-Teilschaltkreis
- 406: erster Ausgangsanschluss
- 407: dritter Knoten
- 408: erster Varaktor
- 409: vierter Knoten
- 410: Abstimmungsspannungsquelle
- 411: zweiter Varaktor
- 412: fünfter Knoten
- 413: sechster Knoten
- 414: zweiter Ausgangsanschluss
- 415: siebter Knoten
- 416: Koppeltransistor-Teilschaltkreis
- 417: achter Knoten
- 418: neunter Knoten
- 419: zweiter Oszillatortransistor-Teilschaltkreis
- 420: erste Source/Drain-Anschluss eines ersten Transistors
- 421: erster Transistor
- 422: zweiter Source/Drain-Anschluss des ersten Transistors
- 423: zehnter Knoten
- 424: Bulk-Anschluss des ersten Transistors
- 425: Versorgungsspannungsquelle
- 426: Gateanschluss des ersten Transistors
- 427: erster Eingangsanschluss
- 428: elfter Knoten
- 429: erste Source/Drain-Anschluss eines zweiten Transistors
- 430: zweiter Transistor
- 431: zweiter Source/Drain-Anschluss des zweiten Transistors
- 432: Bulk-Anschluss des zweiten Transistors
- 433: Versorgungsspannungsquelle
- 434: Gateanschluss des zweiten Transistors
- 435: zweiter Eingangsanschluss
- 400a: erste Oszillatorstufe
- 400c: dritte Oszillatorstufe
- 406a: erster Ausgangsanschluss der ersten Oszillatorstufe
- 406c: erster Ausgangsanschluss der dritten Oszillatorstufe
- 414a: zweiter Ausgangsanschluss der ersten Oszillatorstufe
- 414c: zweiter Ausgangsanschluss der dritten Oszillatorstufe
- 427a: ersten Eingangsanschluss der ersten Oszillatorstufe
- 427c: ersten Eingangsanschluss der dritten Oszillatorstufe
- 435a: zweiter Eingangsanschluss der ersten Oszillatorstufe
- 435c: zweiter Eingangsanschluss der dritten Oszillatorstufe
- 500: Oszillatorstufe
- 516: Koppeltransistor-Teilschaltkreis
- 517: neunter Knoten
- 519: zweiter Oszillatortransistor-Teilschaltkreis
- 528: elfter Knoten
- 536: zwölfter Knoten
- 537: dreizehnter Knoten
- 538: erste Source/Drain-Anschluss eines dritten Transistors
- 539: dritter Transistor
- 540: zweiter Source/Drain-Anschluss des dritten Transistors
- 541: vierzehnter Knoten
- 542: fünfzehnter Knoten
- 543: Versorgungsspannungsquelle
- 544: Gateanschluss des dritten Transistors
- 545: dritter Eingangsanschluss
- 546: Bulk-Anschluss eines vierten Transistors
- 547: Versorgungsspannungsquelle
- 548: Gateanschluss des vierten Transistors
- 549: vierter Eingangsanschluss
- 550: Oszillatorstufe
- 551: Koppeltransistor-Teilschaltkreis
- 552: sechzehnter Knoten
- 553: siebzehnter Knoten
- 554: erste Source/Drain-Anschluss eines fünften Transistors
- 555: fünfter Transistor
- 556: zweiter Source/Drain-Anschluss des fünften Transistors
- 557: achtzehnter Knoten
- 558: Bulk-Anschluss des ersten Transistors.
- 559: Versorgungsspannungsquelle
- 560: Gateanschluss des fünften Transistors
- 561: fünfter Eingangsanschluss
- 562: neunzehnter Knoten
- 563: erste Source/Drain-Anschluss eines sechsten Transistors
- 564: sechster Transistor
- 565: zweiter Source/Drain-Anschluss des sechsten Transistors
- 566: Versorgungsspannungsquelle
- 567: Gateanschluss des sechsten Transistors
- 568: sechster Eingangsanschluss
- 570: erste Source/Drain-Anschluss des vierten Transistors
- 571: vierten Transistor
- 572: zweiter Source/Drain-Anschluss des vierten Transistors
- 573: Bulk-Anschluss des dritten Transistors
- 574: Bulk-Anschluss des sechsten Transistors
- 550a: erste Oszillatorstufe
- 550b: zweite Oszillatorstufe
- 550c: dritte Oszillatorstufe .
- 550d: vierte Oszillatorstufe
- 506a: erster Ausgangsanschluss der ersten Oszillatorstufe
- 506b: erster Ausgangsanschluss der zweiten Oszillatorstufe
- 506c: erster Ausgangsanschluss der dritten Oszillatorstufe
- 506d: erster Ausgangsanschluss der vierten Oszillatorstufe
- 514a: zweiter Ausgangsanschluss der ersten Oszillatorstufe
- 514b: zweiter Ausgangsanschluss der zweiten Oszillatorstufe
- 514c: zweiter Ausgangsanschluss der dritten Oszillatorstufe
- 514d: zweiter Ausgangsanschluss der vierten Oszillatorstufe
- 527a: ersten Eingangsanschluss der ersten Oszillatorstufe
- 527b: ersten Eingangsanschluss der zweiten Oszillatorstufe
- 527c: ersten Eingangsanschluss der dritten Oszillatorstufe
- 527d: ersten Eingangsanschluss der vierten Oszillatorstufe
- 535a: zweiter Eingangsanschluss der ersten Oszillatorstufe
- 535b: zweiter Eingangsanschluss der zweiten Oszillatorstufe
- 535c: zweiter Eingangsanschluss der dritten Oszillatorstufe
- 535d: zweiter Eingangsanschluss der vierten Oszillatorstufe
- 545a: dritter Eingangsanschluss der ersten Oszillatorstufe
- 545b: dritter Eingangsanschluss der zweiten Oszillatorstufe
- 545c: dritter Eingangsanschluss der dritten Oszillatorstufe
- 545d: dritter Eingangsanschluss der vierten Oszillatorstufe
- 549a: vierter Eingangsanschluss der ersten Oszillatorstufe
- 549b: vierter Eingangsanschluss der zweiten Oszillatorstufe
- 549c: vierter Eingangsanschluss der dritten Oszillatorstufe
- 549d: vierter Eingangsanschluss der vierten Oszillatorstufe
- 601: Versorgungsspannungsanschluss
- 602: Bezugsspannungsanschluss
- 603: Abstimmspannungsanschluss
- 700: erste Kurve
- 701: zweite Kurve
- 702: dritte Kurve
- 703: erste Kurve
- 704: zweite Kurve
- 705: dritte Kurve
- 706: erste Kurve
- 707: zweite Kurve
- 708: dritte Kurve
- 800: erste Kurve
- 801: zweite Kurve
- 802: erste Kurve
- 803: zweite Kurve
- 804: erste Kurve
- 805: zweite Kurve
- 1000: VCO gemäß Stand der Technik
- 1001: Induktivität
- 1002: erster Knoten
- 1003: zweiter Knoten
- 1004: dritter Knoten
- 1005: erster Ausgangsanschluss
- 1006: vierter Knoten
- 1007: erster Varaktor
- 1008: fünfter Knoten
- 1009: zweiter Varaktor
- 1010: Abstimmspannungsquelle
- 1011: sechster Knoten
- 1012: siebter Knoten
- 1013: zweiter Ausgangsanschluss
- 1014: LC-Glied
- 1015: Oszillatortransistor-Teilschaltkreis
- 1016: Koppeltransistor-Teilschaltkreis
- 1017: achter Knoten
- 1018: erster Source/Drain-Anschluss eines ersten Transistors
- 1019: erster Transistor
- 1020: zweiter Source/Drain-Anschluss des ersten Transistors
- 1021: neunter Knoten
- 1022: Bezugsspannungsquelle
- 1023: Gateanschluss des ersten Transistors
- 1024: zehnter Knoten
- 1025: erster Source/Drain-Anschluss eines zweiten Transistors
- 1026: zweiter Transistor
- 1027: zweiter Source/Drain-Anschluss des zweiten Transistors
- 1028: Gateanschluss des zweiten Transistors
- 1029: erster Source/Drain-Anschluss eines dritten Transistors
- 1030: dritter Transistor
- 1031: zweiter Source/Drain-Anschluss des dritten Transistors
- 1032: zwölfter Knoten
- 1033: Versorgungsspannungsquelle
- 1034: Gateanschluss des dritten Transistors
- 1035: dreizehnter Knoten
- 1036: erster Source/Drain-Anschluss eines vierten Transistors
- 1037: vierter Transistor
- 1038: zweiter Source/Drain-Anschluss des vierten Transistors
- 1039: Gateanschluss des vierten Transistors
- 1040: elfter Knoten
- 1100: Oszillatorstufe
- 1101: erster Spannungsversorgungsanschluss
- 1102: zweiter Spannungsversorgungsanschluss
- 1103: dritter Spannungsversorgungsanschluss
- 1104: erster Kopplungseingang
- 1105: zweiter Kopplungseingang
- 1106: erster Kopplungsausgang
- 1107: zweiter Kopplungsausgang
- 1100a: erste Oszillatorstufe
- 1104a: erster Kopplungseingang der ersten Oszillatorstufe
- 1105a: zweiter Kopplungseingang der ersten Oszillatorstufe
- 1106a: erster Kopplungsausgang der ersten Oszillatorstufe
- 1107a: zweiter Kopplungsausgang der ersten Oszillatorstufe
- 1100b: zweite Oszillatorstufe
- 1104b: erster Kopplungseingang der zweiten Oszillatorstufe
- 1105b: zweiter Kopplungseingang der zweiten Oszillatorstufe
- 1106b: erster Kopplungsausgang der zweiten Oszillatorstufe
- 1107b: zweiter Kopplungsausgang der zweiten Oszillatorstufe
- 1100c: dritte Oszillatorstufe
- 1104c: erster Kopplungseingang der dritten Oszillatorstufe
- 1105c: zweiter Kopplungseingang der dritten Oszillatorstufe
- 1106c: erster Kopplungsausgang der dritten Oszillatorstufe
- 1107c: zweiter Kopplungsausgang der dritten Oszillatorstufe
- 1300: Induktivität
- 1301: erster Knoten
- 1302: zweiter Knoten
- 1303: erster Ausgangsanschluss
- 1304: dritter Knoten
- 1305: vierter Knoten
- 1306: erster Source/Drain-Anschluss eines ersten Transistors
- 1307: erster Transistor
- 1308: zweiter Source/Drain-Anschluss des ersten Transistors
- 1309: erster Source/Drain-Anschluss eines zweiten Transistors
- 1310: zweiter Transistor
- 1311: Bulk-Anschluss des ersten Transistors
- 1312: Bezugsspannungsquelle
- 1313: zweiter Source/Drain-Anschluss des zweiten Transistors
- 1314: fünfter Knoten
- 1315: Bulk-Anschluss des zweiten Transistors
- 1316: Bezugsspannungsquelle
- 1317: erster Source/Drain-Anschluss eines dritten Transistors
- 1318: dritter Transistor
- 1319: Bulk-Anschluss des ersten Transistors
- 1320: zweiter Source/Drain-Anschluss des dritten Transistors
- 1321: erster Source/Drain-Anschluss eines vierten Transistors
- 1322: vierter Transistor
- 1323: Gateanschluss des dritten Transistors
- 1324: zweiter Source/Drain-Anschluss des vierten Transistors
- 1325: sechster Knoten
- 1326: Bulk-Anschluss des vierten Transistors
- 1327: Bezugsspannungsquelle
- 1328: Gateanschluss des zweiten Transistors
- 1329: siebter Knoten
- 1330: achter Knoten
- 1331: erster Varaktor
- 1332: neunter Knoten
- 1333: Abstimmspannungsquelle
- 1334: zweiter Varaktor
- 1335: zweiter Ausgangsanschluss
- 1336: zehnter Knoten
- 1337: elfter Knoten
- 1338: erster Source/Drain-Anschluss eines fünften Transistors
- 1339: fünfter Transistor
- 1340: zweiter Source/Drain-Anschluss des fünften Transistors
- 1341: erster Source/Drain-Anschluss eines sechsten Transistors
- 1342: sechster Transistor
- 1343: Bulk-Anschluss des fünften Transistors
- 1344: erste Versorgungsspannungsquelle
- 1345: zweiter Source/Drain-Anschluss des sechsten Transistors
- 1346: zwölfter Knoten
- 1347: Bulk-Anschluss des sechsten Transistors
- 1348: erster Source/Drain-Anschluss eines siebten Transistors
- 1349: siebter Transistor
- 1350: zweiter Source/Drain-Anschluss des siebten Transistors
- 1351: erster Source/Drain-Anschluss eines achten Transistors
- 1352: achter Transistor
- 1353: Bulk-Anschluss des achten Transistors
- 1354: Gateanschluss des siebten Transistors
- 1355: zweiter Source/Drain-Anschluss des achten Transistors
- 1356: dreizehnter Knoten
- 1357: Bulk-Anschluss des achten Transistors
- 1358: dritte Versorgungsspannungsquelle
- 1359: Gateanschluss des sechsten Transistors
- 1360: Gateanschluss des ersten Transistors
- 1361: vierzehnter Knoten
- 1362: Gateanschluss des achten Transistors
- 1363: erster Eingangsanschluss
- 1364: Gateanschluss des vierten Transistors
- 1365: fünfzehnter Knoten
- 1366: Gateanschluss des fünften Transistors
- 1367: zweiter Eingangsanschluss
- 1368: zweite Versorgungsspannungsquelle
- 1400: Induktivität
- 1401: erster Knoten
- 1402: zweiter Knoten
- 1403: erster Ausgangsanschluss
- 1404: dritter Knoten
- 1405: vierter Knoten
- 1406: fünfter Knoten
- 1407: erster Source/Drain-Anschluss eines ersten Transistors
- 1408: erster Transistor
- 1409: zweiter Source/Drain-Anschluss des ersten Transistors
- 1410: sechster Knoten
- 1411: Bulk-Anschluss des ersten Transistors
- 1412: siebter Knoten
- 1413: achter Knoten
- 1414: Bezugsspannungsquelle
- 1415: neunter Knoten
- 1416: erster Source/Drain-Anschluss eines zweiten Transistors
- 1417: zweiter Transistor
- 1418: Bulk-Anschluss des zweiten Transistors
- 1419: zweiter Source/Drain-Anschluss des zweiten Transistors
- 1420: zehnter Knoten
- 1421: elfter Knoten
- 1422: zwölfter Knoten
- 1423: Gateanschluss des ersten Transistors
- 1424: Gateanschluss des zweiten Transistors
- 1425: dreizehnter Knoten
- 1426: vierzehnter Knoten
- 1427: Abstimmungsspannungsquelle
- 1428: zweiter Varaktor
- 1429: fünfzehnter Knoten
- 1430: zweiter Ausgangsanschluss
- 1431: sechzehnter Knoten
- 1432: erster Source/Drain-Anschluss eines dritten Transistors
- 1433: dritter Transistor
- 1434: zweiter Source/Drain-Anschluss des dritten Transistors
- 1435: siebzehnter Knoten
- 1436: Bulk-Anschluss des dritten Transistors
- 1437: achtzehnter Knoten
- 1438: neunzehnter Knoten
- 1439: Versorgungsspannungsquelle
- 1440: zwanzigster Knoten
- 1441: erster Source/Drain-Anschluss eines vierten Transistors
- 1442: vierter Transistor
- 1443: Bulk-Anschluss des vierten Transistors
- 1444: zweiter Source/Drain-Anschluss des vierten Transistors
- 1445: einundzwanzigster Knoten
- 1446: zweiundzwanzigster Knoten
- 1447: Gateanschluss des dritten Transistors
- 1448: Gateanschluss des vierten Transistors
- 1449: erster Source/Drain-Anschluss eines fünften Transistors
- 1450: fünfter Transistor
- 1451: zweiter Source/Drain-Anschluss des fünften Transistors
- 1452: Gateanschluss des fünften Transistors
- 1453: dreiundzwanzigster Knoten
- 1454: erster Eingangsanschluss
- 1455: Gateanschluss eines sechsten Transistors
- 1456: sechster Transistor
- 1457: erster Source/Drain-Anschluss eines sechsten Transistors
- 1458: zweiter Source/Drain-Anschluss des sechsten Transistors
- 1459: Bulk-Anschluss des sechsten Transistors
- 1460: erster Source/Drain-Anschluss eines siebten Transistors
- 1461: siebter Transistor
- 1462: zweiter Source/Drain-Anschluss des siebten Transistors
- 1463: Gateanschluss des siebten Transistors
- 1464: vierundzwanzigster Knoten
- 1465: zweiter Ausgangsanschluss
- 1466: Gateanschluss eines achten Transistors
- 1467: achter Transistor
- 1468: erster Source/Drain-Anschluss eines achten Transistors
- 1469: zweiter Source/Drain-Anschluss des achten Transistors
- 1470: Bulk-Anschluss des achten Transistors
- 1471: erster Varaktor
- 1472: Bulk-Anschluss des fünften Transistors
- 1473: Bulk-Anschluss des siebten Transistors

## Patentansprüche

1. Injection-Locked-Oscillator-Schaltkreis (300)
mit mindestens zwei Oszillatorstufen (301,302), wobei jede Oszillatorstufe aufweist:
eine Induktivität (313),
eine Kapazität (312), welche parallel zu der Induktivität geschaltet ist,
mindestens einen Ausgangsknoten (314,315),
**gekennzeichnet durch** einen Kopplungs-Schaltelement-Teilschaltkris (316,337) mit mindestens einem Kopplungs-Schaltelement (329,339), welches derart parallel zu der Induktivität und der Kapazität gekoppelt ist, dass seriell jeweils genau ein Kopplungs-Schaltelement vorhanden ist, und
mindestens einen Eingangsanschluss (342,343), welcher mittels des Steueranschlusses des Kopplungs-Schaltelements gebildet ist,
wobei die Oszillatorstufen des Injection-Locked-Oscillator-Schaltkreises mittels der Kopplungs-Schaltelement-Teilschaltkreise gekoppelt sind.

2. Injection-Locked-Oscillator-Schaltkreis gemäß Anspruch 1, bei dem jede Oszillatorstufe genau zwei Ausgangsanschlüsse aufweist, an welchen Signale anliegen, welche differentiell zueinander sind.

3. Injection-Locked-Oscillator-Schaltkreis gemäß Anspruch 1 oder 2, bei dem der Kopplungs-Schaltelement-Teilschaltkreis zwei zusätzliche miteinander verschaltete Kopplungs-Schaltelemente aufweist, welche jeweils parallel zu den miteinander verschalteten Kopplungs-Schaltelementen geschaltet sind.

4. Injection-Locked-Oscillator-Schaltkreis gemäß einem der Ansprüche 1 bis 3, bei dem die Kopplungs-Schaltelemente Transistoren sind.

5. Injection-Locked-Oscillator-Schaltkreis gemäß Anspruch 4, bei dem die Transistoren NMOS- und/oder PMOS-Transistoren sind.

6. Injection-Locked-Oscillator-Schaltkreis gemäß Anspruch 5, bei dem jeweils einer der parallel geschalteten Transistoren ein PMOS-Transistor und der andere parallel geschaltete Transistor ein NMOS-Transistor ist.

7. Injection-Locked-Oscillator-Schaltkreis gemäß einem der Ansprüche 1 bis 6, bei dem die Kapazitäten mittels Varaktoren ausgebildet sind.

8. Injection-Locked-Oscillator-Schaltkreis gemäß einem der Ansprüche 1 bis 7, bei dem die Oszillatorstufen ein aktives Element aufweisen.

9. Injection-Locked-Oscillator-Schaltkreis gemäß einem der Ansprüche 1 bis 8, bei dem eine gerade Anzahl von Oszillatorstufen zu einem Injection-Locked-Oscillator-Schaltkreis gekoppelt ist.

10. Injection-Locked-Oscillator-Schaltkreis gemäß Anspruch 9, bei dem die Anzahl der Eingangsanschlüsse jeder Oszillatorstufe gleich der Anzahl von Oszillatorstufen des Injection-Locked-Oscillator-Schaltkreises ist.

11. Injection-Locked-Oscillator-Schaltkreis gemäß Anspruch 9 oder 10, bei den der Injection-Locked-Oscillator-Schaltkreis vier Oszillatorstufen aufweist, wobei jede Oszillatorstufe genau vier Eingangsanschlüsse und genau zwei Ausgangsanschlüsse aufweist und wobei zwei der Eingangsanschlüsse mit den Ausgangsanschlüssen einer in Signalflussrichtung vorangegangenen Oszillatorstufe des Injection-Locked-Oscillator-Schaltkreises gekoppelt sind und die anderen beiden Eingangsanschlüsse mit den Ausgangsanschlüssen der in Signalflussrichtung nachfolgenden Injection-Locked-Oscillator-Schaltkreises gekoppelt sind.

12. Injection-Locked-Oscillator-Schaltkreis gemäß einem der Ansprüche 1 bis 8, bei dem der Injection-Locked-Oscillator-Schaltkreis eine ungerade Anzahl von Oszillatorstufen aufweist.

## Claims

1. An injection-locked oscillator circuit (300)
comprising at least two oscillator stages (301, 302), each oscillator stage comprising:
an inductance (313),
a capacitance (312) connected in parallel with the inductance,
at least one output node (314, 315),
**characterized in that**
the injection-locked oscillator circuit further comprises a coupling-switching element subcircuit (316, 337) comprising at least one coupling-switching element (329, 339) which is coupled in parallel with the inductance and the capacitance in such a way that in each case precisely one coupling-switching element is present serially, and
at least one input terminal (342, 343) formed by means of the control terminal of the coupling-switching element,
the oscillator stages of the injection-locked oscillator circuit being coupled by means of the coupling-switching element subcircuits.

2. The injection-locked oscillator circuit as claimed in claim 1, in which each oscillator stage has precisely two output terminals at which signals that are differential with respect to one another are present.

3. The injection-locked oscillator circuit as claimed in claim 1 or 2, in which the coupling-switching element subcircuit comprises two additional coupling-switching elements which are connected up to one another and are in each case connected in parallel with the coupling-switching elements connected up to one another.

4. The injection-locked oscillator circuit as claimed in one of claims 1 to 3, in which the coupling-switching elements are transistors.

5. The injection-locked oscillator circuit as claimed in claim 4, in which the transistors are NMOS and/or PMOS transistors.

6. The injection-locked oscillator circuit as claimed in claim 5, in which a respective one of the transistors connected in parallel is a PMOS transistor and the other transistor connected in parallel is an NMOS transistor.

7. The injection-locked oscillator circuit as claimed in one of claims 1 to 6, in which the capacitances are formed by means of varactors.

8. The injection-locked oscillator circuit as claimed in one of claims 1 to 7, in which the oscillator stages comprise an active element.

9. The injection-locked oscillator circuit as claimed in one of claims 1 to 8, in which an even number of oscillator stages are coupled to form an injection-locked oscillator circuit.

10. The injection-locked oscillator circuit as claimed in claim 9, in which the number of input terminals of each oscillator stage is equal to the number of oscillator stages of the injection-locked oscillator circuit.

11. The injection-locked oscillator circuit as claimed in claim 9 or 10, in which the injection-locked oscillator circuit comprises four oscillator stages, each oscillator stage comprising precisely four input terminals and precisely two output terminals, and two of the input terminals being coupled to the output terminals of a preceding oscillator stage of the injection-locked oscillator circuit in the signal flow direction, and the other two input terminals being coupled to the output terminals of the downstream injection-locked oscillator circuit in the signal flow direction.

12. The injection-locked oscillator circuit as claimed in one of claims 1 to 8, in which the injection-locked oscillator circuit comprises an odd number of oscillator stages.

## Revendications

1. Circuit (300) oscillateur verrouillé par injection
ayant au moins deux étages (301, 302) d'oscillateur, chaque étage d'oscillateur comportant:
une inductance (313),
une capacité (312) qui est montée en parallèle à l'inductance,
au moins un noeud (314, 315) de sortie,
**caractérisé par** un sous-circuit (316, 337) de commutation couplage-élément de commutation ayant au moins un élément (329, 339) de couplage-commutation qui est monté en parallèle à l'inductance et à la capacité, de façon à ce qu'il y ait en série, respectivement, exactement un élément de couplage-commutation et
au moins une borne (342, 343) d'entrée qui est formée au moyen de la borne de commande de l'élément de couplage-commutation,
dans lequel les étages d'oscillateur du circuit oscillateur verrouillé par injection sont couplés au moyen du sous-circuit de commutation couplage-élément de commutation.

2. Circuit d'oscillateur verrouillé par injection suivant la revendication 1, dans lequel chaque étage d'oscillateur a exactement deux bornes de sortie sur lesquelles s'appliquent des signaux qui sont différentiels les uns par rapport aux autres.

3. Circuit d'oscillateur verrouillé par injection suivant la revendication 1 ou 2, dans lequel le sous-circuit de commutation couplage-élément de commutation a deux éléments de couplage-commutation supplémentaires câblés entre eux qui sont montés respectivement en parallèle aux éléments de couplage-commutation câblés entre eux.

4. Circuit d'oscillateur verrouillé par injection suivant l'une des revendications 1 à 3, dans lequel les éléments de couplage-commutation sont des transistors.

5. Circuit d'oscillateur verrouillé par injection suivant la revendication 4, dans lequel les transistors sont des transistors NMOS et/ou PMOS.

6. Circuit d'oscillateur verrouillé par injection suivant la revendication 5, dans lequel respectivement l'un des transistors montés en parallèle est un transistor PMOS et l'autre transistor monté en parallèle est un transistor NMOS.

7. Circuit d'oscillateur verrouillé par injection suivant l'une des revendications 1 à 6, dans lequel les capacités sont constituées au moyen de varactances.

8. Circuit d'oscillateur verrouillé par injection suivant l'une des revendications 1 à 7, dans lequel les étages d'oscillateur ont un élément actif.

9. Circuit d'oscillateur verrouillé par injection suivant l'une des revendications 1 à 8, dans lequel un nombre pair d'étages d'oscillateur est couplé à un circuit d'oscillateur verrouillé par injection.

10. Circuit d'oscillateur verrouillé par injection suivant la revendication 9, dans lequel le nombre des bornes d'entrée de chaque étage d'oscillateur est égal au nombre d'étages d'oscillateur du circuit d'oscillateur verrouillé par injection.

11. Circuit d'oscillateur verrouillé par injection suivant la revendication 9 ou 10, dans lequel le circuit d'oscillateur verrouillé par injection a quatre étages d'oscillateur, chaque étage d'oscillateur a exactement quatre bornes d'entrée et exactement deux bornes de sortie et dans lequel deux des bornes d'entrée sont couplées aux bornes de sortie d'un étage d'oscillateur précédent dans le sens de passage du signal du circuit d'oscillateur verrouillé par injection et les deux autres bornes d'entrée sont couplées aux bornes de sortie du circuit d'oscillateur verrouillé par injection suivant dans le sens de passage du signal.

12. Circuit d'oscillateur verrouillé par injection suivant l'une des revendications 1 à 8, dans lequel le circuit d'oscillateur verrouillé par injection a un nombre impair d'étages d'oscillateur.
